# EUROPEAN PATENT APPLICATION

(11) **EP 4 478 865 A1**
(43) Date of publication of application: **18.12.2024**
(21) Application number: 24181247.8
(22) Date of filing: 10.06.2024
(51) Int. Cl.: H10K 59/35, H10K 59/122, H10K 71/20, H10K 50/844

(54) **DISPLAY DEVICE AND METHOD OF MANUFACTURING THE SAME**

(30) Priority: 16.06.2023 KR 20230077407
(71) Applicant: Samsung Display Co., Ltd., Gyeonggi-do 17113 (KR)
(72) Inventor: YANG, Hee Jun, Yongin-si (KR); SUNG, Woo Yong, Yongin-si (KR); LEE, Jeong Seok, Yongin-si (KR)
(74) Representative: Marks & Clerk LLP

(57) **Abstract**

A display device comprises a first pixel electrode disposed on a substrate in a first emission area, a second pixel electrode disposed on the substrate in a second emission area, an insulating layer covering edges of an upper surface of each of the first and second pixel electrodes, a first light emitting layer disposed on the first pixel electrode and the insulating layer, a first common electrode disposed on the first light emitting layer, a first bank disposed on the insulating layer, a second bank disposed on the first bank and including tips that protrude from side surfaces of the first bank toward each of the first and second emission areas, a first residual inorganic layer disposed on lower surfaces of the tips of the second bank adjacent to the second emission area, and a first oxide layer covering a lower surface of the first residual inorganic layer.

## Description

### BACKGROUND

### 1. Technical Field

The disclosure relates to a display device and a method of manufacturing the same.

### 2. Description of the Related Art

As the information society develops, demands for display devices for displaying images are increasing in various forms. For example, display devices are applied to various electronic devices such as smartphones, digital cameras, notebook computers, navigation devices, and smart televisions. The display devices may be flat panel display devices such as liquid crystal display devices, field emission display devices, and organic light emitting display devices. Among these flat panel display devices, a light emitting display device includes a light emitting element that enables each pixel of a display panel to emit light by itself. Thus, the light emitting display device can display an image without a backlight unit that provides light to the display panel.

### SUMMARY

Aspects of the disclosure provide a display device capable of securing reliability of light emitting elements while minimizing a mask process, and a method of manufacturing the display device.

However, aspects of the disclosure are not restricted to the one set forth herein. The above and other aspects of the disclosure will become more apparent to one of ordinary skill in the art to which the disclosure pertains by referencing the detailed description of the disclosure given below.

According to an embodiment, a display device comprises a first pixel electrode disposed on a substrate in a first emission area, a second pixel electrode disposed on the substrate in a second emission area, the first and second pixel electrodes being disposed on a same layer, an insulating layer covering edges of an upper surface of each of the first and second pixel electrodes, a first light emitting layer disposed on the first pixel electrode and the insulating layer, a first common electrode disposed on the first light emitting layer, a first bank disposed on the insulating layer, a second bank disposed on the first bank and including tips that protrude from side surfaces of the first bank toward each of the first and second emission areas, a first residual inorganic layer disposed on lower surfaces of the tips of the second bank adjacent to the second emission area, and a first oxide layer covering a lower surface of the first residual inorganic layer.

The display device may further comprise a capping layer disposed on the first common electrode in the first emission area, and a first inorganic layer covering an upper surface of the capping layer of the first emission area, the side surfaces of the first bank, and lower surfaces and side surfaces of the tips of the second bank.

The first residual inorganic layer and the first inorganic layer may include a same material.

The first oxide layer may be formed by oxidation of a surface of the first residual inorganic layer.

The display device may further comprise a second light emitting layer disposed on the second pixel electrode and the insulating layer, a second common electrode disposed on the second light emitting layer, and a third pixel electrode disposed in a third emission area, the first, second, and third pixel electrodes being disposed on a same layer. The second bank may include tips protruding toward the third emission area.

The first residual inorganic layer may be additionally disposed on the lower surfaces of the tips of the second bank adjacent to the third emission area, and the first oxide layer may additionally cover the lower surface of the first residual inorganic layer adjacent to the third emission area.

The display device may further comprise a second residual inorganic layer disposed on a lower surface of the first oxide layer adjacent to the third emission area, and a second oxide layer covering a lower surface of the second residual inorganic layer.

The display device may further comprise a capping layer disposed on the second common electrode in the second emission area, and a second inorganic layer covering an upper surface of the capping layer of the second emission area, the side surfaces of the first bank, lower surfaces and side surfaces of the first oxide layer, and the side surfaces of the tips of the second bank.

The second residual inorganic layer and the second inorganic layer may include a same material.

The second oxide layer may be formed by oxidation of a surface of the second residual inorganic layer.

The display device may further comprise a third bank disposed on the second bank, and a fourth bank disposed on the third bank and including tips that protrude from side surfaces of the third bank toward each of the first and second emission areas.

According to an embodiment, a display device comprises a first pixel electrode disposed on a substrate in a first emission area, a second pixel electrode disposed on a substrate in a second emission area, the first and second pixel electrodes being disposed on a same layer, a residual pattern disposed on edges of an upper surface of each of the first and second pixel electrodes, an insulating layer covering edges of the first and second pixel electrodes and an upper surface of the residual pattern, a first light emitting layer disposed on the first pixel electrode and the insulating layer, a first common electrode disposed on the first light emitting layer, a first bank disposed on the insulating layer, a second bank disposed on the first bank, and a third bank disposed on the second bank and including tips that protrude from side surfaces of the second bank toward each of the first and second emission areas. The second bank and the residual pattern include a same material, and the third bank and the insulating layer include a same material.

The display device may further comprise a first residual inorganic layer disposed on lower surfaces of tips of the second bank adjacent to the second emission area, and a first oxide layer covering a lower surface of the first residual inorganic layer.

The display device may further comprise a second light emitting layer disposed on the second pixel electrode and the insulating layer, a second common electrode disposed on the second light emitting layer, and a third pixel electrode disposed in a third emission area, the first, second, and third pixel electrodes being disposed on a same layer. The third bank may include tips protruding toward the third emission area.

The display device may further comprise a first residual inorganic layer disposed on lower surfaces of the tips of the third bank adjacent to the third emission area, a first oxide layer covering a lower surface of the first residual inorganic layer, a second residual inorganic layer disposed on a lower surface of the first oxide layer, and a second oxide layer covering a lower surface of the second residual inorganic layer.

According to an embodiment, a method of manufacturing a display device comprises forming a first pixel electrode in a first emission area, forming a second pixel electrode in a second emission area, and forming a third pixel electrode in a third emission area on a substrate, sequentially stacking a sacrificial layer, an insulating layer, a first bank, and a second bank on the first through third pixel electrodes, forming tips of the second bank which protrude from side surfaces of the first bank by etching the second bank and the first bank, exposing the first through third pixel electrodes by etching the insulating layer and the sacrificial layer, sequentially stacking a first light emitting layer, a first common electrode and a capping layer on the first pixel electrode and sequentially stacking a first organic pattern, a first electrode pattern, and a first capping pattern in areas other than the first emission area, forming a first inorganic layer on the capping layer and the first capping pattern, and forming a first residual inorganic layer on lower surfaces of the tips of the second bank adjacent to each of the second and third emission areas by etching the first inorganic layer in the areas other than the first emission area.

The method may further comprise forming a first oxide layer covering a lower surface of the first residual inorganic layer by etching the first organic pattern, the first electrode pattern, and the first capping pattern.

The method may further comprise sequentially stacking a second light emitting layer, a second common electrode and a capping layer on the second pixel electrode and sequentially stacking a second organic pattern, a second electrode pattern and a second capping pattern in areas other than the second emission area, forming a second inorganic layer on the capping layer and the second capping pattern, and forming a second residual inorganic layer on a lower surface of the first oxide layer adjacent to the third emission area by etching the second inorganic layer in the areas other than the second emission area.

The method may further comprise forming a second oxide layer covering a lower surface of the second residual inorganic layer by etching the second organic pattern, the second electrode pattern, and the second capping pattern.

The method may further comprise sequentially stacking a third light emitting layer, a third common electrode and a capping layer on the third pixel electrode and sequentially stacking a third organic pattern, a third electrode pattern and a third capping pattern in areas other than the third emission area, forming a third inorganic layer on the capping layer and the third capping pattern, and etching the third inorganic layer, the third organic pattern, the third electrode pattern, and the third capping pattern in the areas other than the third emission area.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic perspective view of a display device according to an embodiment;
FIG. 2 is a schematic cross-sectional view of the display device according to the embodiment;
FIG. 3 is a schematic plan view of a display unit of the display device according to the embodiment;
FIG. 4 is a schematic cross-sectional view illustrating pixels of the display device according to the embodiment;
FIG. 5 is a schematic enlarged view of area A1 of FIG. 4;
FIG. 6 is a schematic enlarged view of area A2 of FIG. 4;
FIG. 7 is a schematic enlarged view of area A3 of FIG. 4;
FIG. 8 is a schematic cross-sectional view illustrating pixels of a display device according to an embodiment;
FIG. 9 is a schematic cross-sectional view illustrating pixels of a display device according to an embodiment; and
FIGS. 10 through 20 are schematic cross-sectional views illustrating a process of manufacturing a display device according to an embodiment.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods employing one or more of the disclosure disclosed herein. In other instances, structures and devices are shown in block diagram form in order to avoid unnecessarily obscuring various embodiments. Further, various embodiments may be different, but do not have to be exclusive nor limit the disclosure. For example, specific shapes, configurations, and characteristics of an embodiment may be used or implemented in other embodiments without departing from the disclosure.

Unless otherwise specified, the illustrated embodiments are to be understood as providing features of varying detail of some ways in which the disclosure may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Further, the X-axis, the Y-axis, and the Z-axis are not limited to three axes of a rectangular coordinate system, and thus the X-, Y-, and Z- axes, and may be interpreted in a broader sense. For example, the X-axis, the Y-axis, and the Z-axis may be perpendicular to one another, or may represent different directions that are not perpendicular to one another.

For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, ZZ, or the like. As used herein, the term "and/or" includes any and all combinations of one or more of the associated listed items. The terms "and" and "or" as used herein may mean "and/or."

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, such as "a," and "an," are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature, and the shapes of these regions may not reflect actual shapes of regions of a device and, as such, are not necessarily intended to be limiting.

As customary in the field, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions. Also, each block, unit, part, and/or module of some embodiments may be physically separated into two or more interacting and discrete blocks, units, parts, and/or modules without departing from the scope of the disclosure. Further, the blocks, units, parts, and/or modules of some embodiments may be physically combined into more complex blocks, units, parts, and/or modules without departing from the scope of the disclosure.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, detailed embodiments of the disclosure are described with reference to the accompanying drawings.

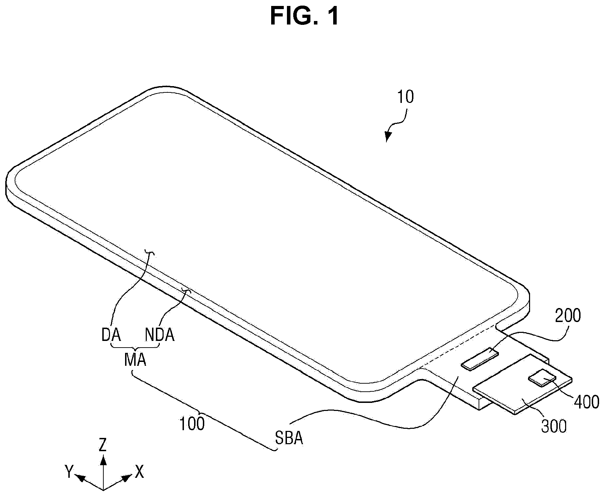

FIG. 1 is a schematic perspective view of a display device 10 according to an embodiment.

Referring to FIG. 1, the display device 10 may be applied to portable electronic devices such as mobile phones, smartphones, tablet personal computers (PCs), mobile communication terminals, electronic notebooks, electronic books, portable multimedia players (PMPs), navigation devices, and ultra-mobile PCs (UMPCs). For example, the display device 10 may be applied as a display unit of a television, a notebook computer, a monitor, a billboard, or an Internet of things (IoT) device. In another example, the display device 10 may be applied to wearable devices such as smart watches, watch phones, glasses-type displays, and head-mounted displays (HMDs).

The display device 10 may have various shapes, such as a planar shape similar to a quadrangle. For example, the display device 10 may have a planar shape similar to a quadrangle having short sides in an X-axis direction and long sides in a Y-axis direction. Each corner where a short side extending in the X-axis direction meets a long side extending in the Y-axis direction may be rounded with a curvature (e.g., a predetermined or selectable curvature) or may be right-angled. The planar shape of the display device 10 is not limited to the quadrangular shape but may also be similar to other polygonal shapes, a circular shape, or an oval shape.

The display device 10 may include a display panel 100, a display driver 200, a circuit board 300, and a touch driver 400.

The display panel 100 may include a main area MA and a sub-area SBA.

The main area MA may include a display area DA including pixels displaying an image and a non-display area NDA disposed around the display area DA. The display area DA may emit light from emission areas or opening areas. For example, the display panel 100 may include pixel circuits including switching elements, a pixel defining layer defining the emission areas or the opening areas, and self-light emitting elements.

For example, examples of the self-light emitting elements may include, but are not limited to, at least one of an organic light emitting diode including an organic light emitting layer, a quantum dot light emitting diode including a quantum dot light emitting layer, an inorganic light emitting diode including an inorganic semiconductor, and a micro light emitting diode.

The non-display area NDA may be an area outside the display area DA. The non-display area NDA may be defined as an edge area of the main area MA of the display panel 100. The non-display area NDA may include a gate driver (not illustrated) which supplies gate signals to gate lines and fan-out lines (not illustrated) which connect the display driver 200 and the display area DA.

The sub-area SBA may extend from a side of the main area MA. The sub-area SBA may include a flexible material that can be bent, folded, rolled, etc. For example, in the case that the sub-area SBA is bent, it may be overlapped by (or overlap) the main area MA, e.g., in a thickness direction (Z-axis direction) or in a plan view. The sub-area SBA may include the display driver 200 and a pad unit connected to the circuit board 300. Optionally, the sub-area SBA may be omitted, and the display driver 200 and the pad unit may be disposed in the non-display area NDA.

The display driver 200 may output signals and voltages for driving the display panel 100. The display driver 200 may supply data voltages to data lines. The display driver 200 may supply a power supply voltage to a power line and supply a gate control signal to the gate driver. The display driver 200 may be formed as an integrated circuit and mounted on the display panel 100, e.g., by a chip-on-glass (COG) method, a chip-on-plastic (COP) method, or an ultrasonic bonding method. For example, the display driver 200 may be disposed in the sub-area SBA and may be overlapped by the main area MA, e.g., in the thickness direction (Z-axis direction) by the bending of the sub-area SBA. In another example, the display driver 200 may be mounted on the circuit board 300.

The circuit board 300 may be attached onto the pad unit of the display panel 100 using an anisotropic conductive film. Lead lines of the circuit board 300 may be electrically connected to the pad unit of the display panel 100. The circuit board 300 may be a flexible printed circuit board, a printed circuit board, or a flexible film such as a chip-on-film.

The touch driver 400 may be mounted on the circuit board 300. The touch driver 400 may be electrically connected to a touch sensing unit of the display panel 100. The touch driver 400 may supply a touch driving signal to touch electrodes of the touch sensing unit and sense a change in capacitance between the touch electrodes. For example, the touch driving signal may be a pulse signal having a frequency (e.g., a predetermined or selectable frequency). The touch driver 400 may determine whether an input has been made based on a change in capacitance between the touch electrodes and calculate coordinates of the input. The touch driver 400 may be formed as an integrated circuit.

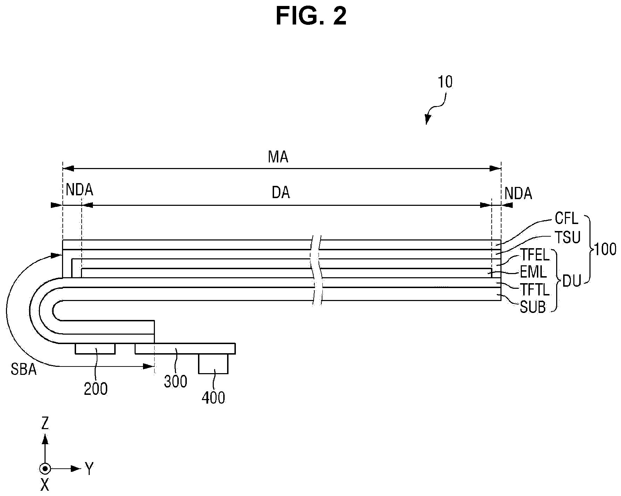

FIG. 2 is a schematic cross-sectional view of the display device 10 according to the embodiment.

Referring to FIG. 2, the display panel 100 may include a display unit DU, a touch sensing unit TSU, and a color filter layer CFL. The display unit DU may include a substrate SUB, a thin-film transistor layer TFTL, a light emitting element layer EML, and an encapsulation layer TFEL.

The substrate SUB may be a base substrate or a base member. The substrate SUB may be a flexible substrate that can be bent, folded, rolled, etc. For example, the substrate SUB may include polymer resin such as polyimide (PI), but the disclosure is not limited thereto. In another example, the substrate SUB may include a glass material or a metal material.

The thin-film transistor layer TFTL may be disposed on the substrate SUB. The thin-film transistor layer TFTL may include thin-film transistors constituting (or forming) pixel circuits of pixels. The thin-film transistor layer TFTL may further include gate lines, data lines, power lines, gate control lines, fan-out lines connecting the display driver 200 and the data lines, and lead lines connecting the display driver 200 and the pad unit. Each of the thin-film transistors may include a semiconductor region, a source electrode, a drain electrode, and a gate electrode. For example, in the case that the gate driver is formed on a side of the non-display area NDA of the display panel 100, it may include thin-film transistors.

The thin-film transistor layer TFTL may be disposed in the display area DA, the non-display area NDA, and the sub-area SBA. The thin-film transistors of the pixels, the gate lines, the data lines, and the power lines of the thin-film transistor layer TFTL may be disposed in the display area DA. The gate control lines and the fan-out lines of the thin-film transistor layer TFTL may be disposed in the non-display area NDA. The lead lines of the thin-film transistor layer TFTL may be disposed in the sub-area SBA.

The light emitting element layer EML may be disposed on the thin-film transistor layer TFTL. The light emitting element layer EML may include light emitting elements, each including a pixel electrode, a light emitting layer and a common electrode sequentially stacked to emit light, and a pixel defining layer defining the pixels. The light emitting elements of the light emitting element layer EMI, may be disposed in the display area DA.

For example, the light emitting layer may be an organic light emitting layer including an organic material. The light emitting layer may include a hole transporting layer, an organic light emitting layer, and an electron transporting layer. In the case that the pixel electrode receives a voltage (e.g., a predetermined or selectable voltage) through a thin-film transistor of the thin-film transistor layer TFTL and the common electrode receives a cathode voltage, holes may move to the organic light emitting layer through the hole transporting layer, and electrons may move to the organic light emitting layer through the electron transporting layer. Then, the holes and the electrons may be combined with each other in the organic light emitting layer to emit light. For example, the pixel electrode may be an anode, and the common electrode may be a cathode, but the disclosure is not limited thereto.

In another example, examples of the light emitting elements may include a quantum dot light emitting diode including a quantum dot light emitting layer, an inorganic light emitting diode including an inorganic semiconductor, or a micro light emitting diode.

The encapsulation layer TFEL may cover upper and side surfaces of the light emitting element layer EML and may protect the light emitting element layer EML. The encapsulation layer TFEL may include at least one inorganic layer and at least one organic layer to encapsulate the light emitting element layer EML.

The touch sensing unit (touch sensing part or touch sensor) TSU may be disposed on the encapsulation layer TFEL. The touch sensing unit TSU may include touch electrodes for sensing a user's touch in a capacitive manner and touch lines connecting the touch electrodes and the touch driver 400. For example, the touch sensing unit TSU may sense a user's touch in a mutual capacitance manner or a self-capacitance manner.

In another example, the touch sensing unit TSU may be disposed on a separate substrate disposed on the display unit (or display part) DU. In this case, the substrate supporting the touch sensing unit TSU may be an encapsulation substrate that encapsulates the display unit DU.

The touch electrodes of the touch sensing unit TSU may be disposed in a touch sensor area overlapping the display area DA. The touch lines of the touch sensing unit TSU may be disposed in a touch peripheral area overlapping the non-display area NDA.

The color filter layer CFL may be disposed on the touch sensing unit TSU. The color filter layer CFL may include color filters corresponding to emission areas, respectively. Each of the color filters may selectively transmit light of a specific wavelength and block or absorb light of other wavelengths. The color filter layer CFL may absorb a part of light coming from the outside of the display device 10, thereby reducing reflected light due to the external light. Therefore, the color filter layer CFL may prevent color distortion due to reflection of external light.

Since the color filter layer CFL may be directly disposed on the touch sensing unit TSU, the display device 10 may not require a separate substrate for the color filter layer CFL. Therefore, a thickness of the display device 10 can be relatively reduced.

The sub-area SBA of the display panel 100 may extend from a side of the main area MA. The sub-area SBA may include a flexible material that can be bent, folded, rolled, etc. For example, in the case that the sub-area SBA is bent, it may be overlapped by the main area MA, e.g., in the thickness direction (Z-axis direction). The sub-area SBA may include the display driver 200 and the pad unit electrically connected to the circuit board 300.

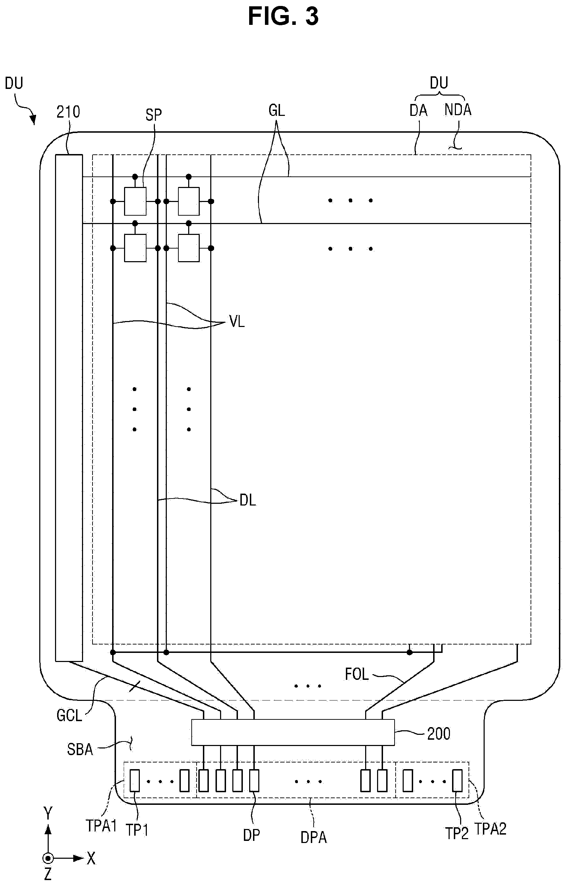

FIG. 3 is a schematic plan view of the display unit DU of the display device 10 according to the embodiment.

Referring to FIG. 3, the display unit DU may include the display area DA and the non-display area NDA.

The display area DA may be an area for displaying an image and may be defined as a central area of the display panel 100. The display area DA may include pixels SP, gate lines GL, data lines DL, and power lines VL. Each of the pixels SP may be defined as a minimum unit that outputs light.

The gate lines GL may supply gate signals received from a gate driver 210 to the pixels SP. The gate lines GL may extend in the X-axis direction and may be spaced apart from each other in the Y-axis direction intersecting the X-axis direction.

The data lines DL may supply data voltages received from the display driver 200 to the pixels SP. The data lines DL may extend in the Y-axis direction and may be spaced apart from each other in the X-axis direction.

The power lines VL may supply a power supply voltage received from the display driver 200 to the pixels SP. Here, the power supply voltage may be, e.g., at least one of a driving voltage, an initialization voltage, a reference voltage, a bias voltage, and a low potential voltage. The power lines VL may extend in the Y-axis direction and may be spaced apart from each other in the X-axis direction.

The non-display area NDA may surround the display area DA. The non-display area NDA may include the gate driver 210, fan-out lines FOL, and gate control lines GCL. The gate driver 210 may generate gate signals based on a gate control signal and sequentially supply the gate signals to the gate lines GL according to a set order.

The fan-out lines FOL may extend from the display driver 200 to the display area DA. The fan-out lines FOL may supply data voltages received from the display driver 200 to the data lines DL.

The gate control lines GCL may extend from the display driver 200 to the gate driver 210. The gate control lines GCL may supply a gate control signal received from the display driver 200 to the gate driver 210.

The sub-area SBAmay include the display driver 200, a display pad area DPA, and first and second touch pad areas TPA1 and TPA2.

The display driver 200 may output signals and voltages for driving the display panel 100 to the fan-out lines FOL. The display driver 200 may supply data voltages to the data lines DL through the fan-out lines FOL. The data voltages may be supplied to the pixels SP and may determine luminances of the pixels SP. The display driver 200 may supply a gate control signal to the gate driver 210 through the gate control lines GCL.

The display pad area DPA, the first touch pad area TPA1, and the second touch pad area TPA2 may be disposed at an edge of the sub-area SBA. The display pad area DPA, the first touch pad area TPA1, and the second touch pad area TPA2 may be electrically connected to the circuit board 300 using a low-resistance high-reliability material such as an anisotropic conductive film or self-assembly anisotropic conductive paste (SAP).

The display pad area DPA may include display pad units (display pad parts or display pads) DP. The display pad units DP may be electrically connected to a graphics system through the circuit board 300. The display pad units DP may be connected to the circuit board 300 to receive digital video data and may supply the digital video data to the display driver 200.

The first touch pad area TPA1 may be disposed on a side of the display pad area DPA and may include first touch pad units TP1. The first touch pad units TP1 may be electrically connected to the touch driver 400 disposed on the circuit board 300. The first touch pad units TP1 may supply touch driving signals to driving electrodes through driving lines.

The second touch pad area TPA2 may be disposed on the other side of the display pad area DPA and may include second touch pad units TP2. The second touch pad units TP2 may be electrically connected to the touch driver 400 disposed on the circuit board 300. The touch driver 400 may receive touch sensing signals through sensing lines connected to the second touch pad units TP2 and sense a change in mutual capacitance between the driving electrodes and sensing electrodes.

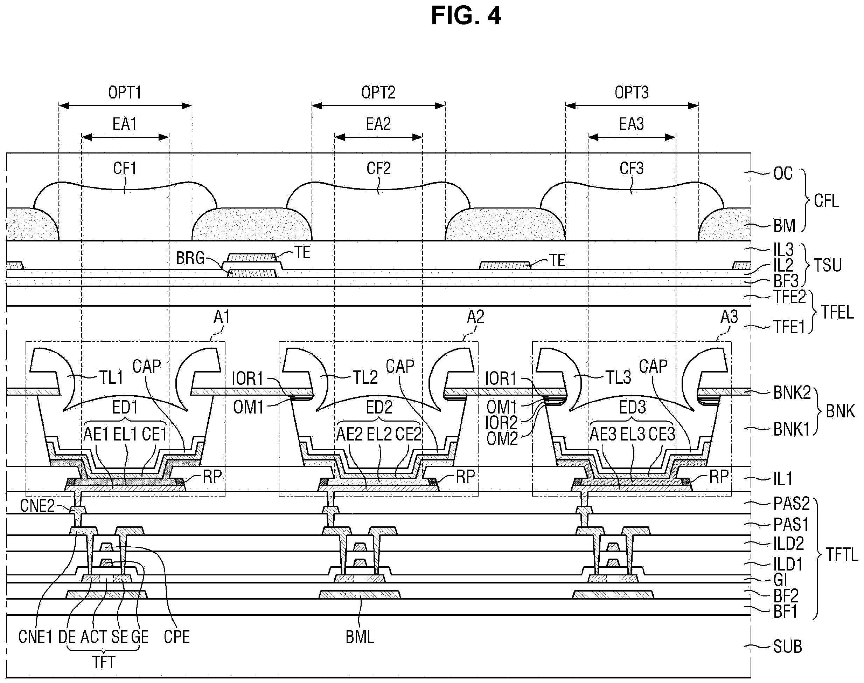

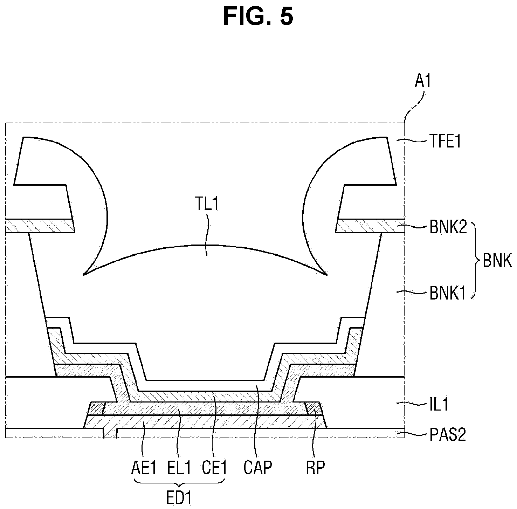

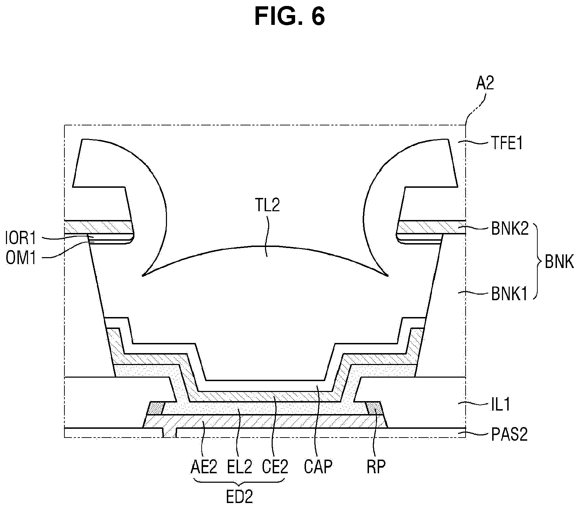

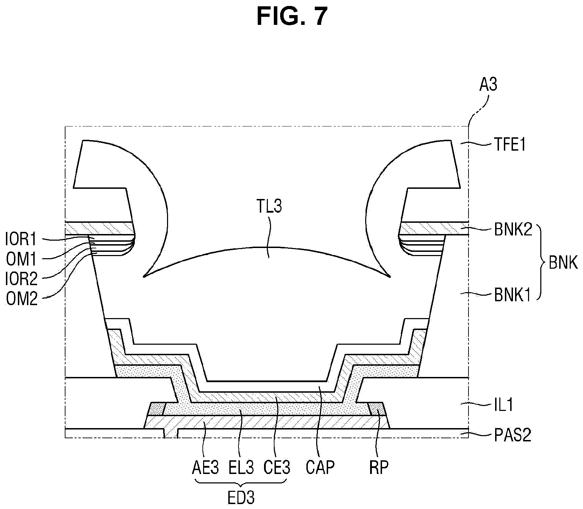

FIG. 4 is a schematic cross-sectional view illustrating pixels of the display device 10 according to the embodiment. FIG. 5 is a schematic enlarged view of area A1 of FIG. 4. FIG. 6 is a schematic enlarged view of area A2 of FIG. 4. FIG. 7 is a schematic enlarged view of area A3 of FIG. 4.

Referring to FIGS. 4 through 7, the display panel 100 may include the display unit DU, the touch sensing unit TSU, and the color filter layer CFL. The display unit DU may include the substrate SUB, the thin-film transistor layer TFTL, the light emitting element layer EML, and the encapsulation layer TFEL.

The substrate SUB may be a base substrate or a base member. The substrate SUB may be a flexible substrate that can be bent, folded, rolled, etc. For example, the substrate SUB may include polymer resin such as polyimide (PI), but the disclosure is not limited thereto. In another example, the substrate SUB may include a glass material or a metal material.

The thin-film transistor layer TFTL may include a first buffer layer BF1, light blocking layers BML, a second buffer layer BF2, thin-film transistors TFT, a gate insulating layer GI, a first interlayer insulating layer ILD1, capacitor electrodes CPE, a second interlayer insulating layer ILD2, first connection electrodes CNE1, a first passivation layer PAS1, second connection electrodes CNE2, and a second passivation layer PAS2.

The first buffer layer BF1 may be disposed on the substrate SUB. The first buffer layer BF1 may include an inorganic layer that can prevent penetration of air or moisture. For example, the first buffer layer BF1 may include inorganic layers stacked on each other alternately.

The light blocking layers BML may be disposed on the first buffer layer BF1. For example, each of the light blocking layers BML may be a single layer or a multilayer made of any one or more of molybdenum (Mo), aluminium (Al), chromium (Cr), gold (Au), titanium (Ti), nickel (Ni), neodymium (Nd), copper (Cu), and alloys thereof. In another example, each of the light blocking layers BML may be an organic layer including a black pigment.

The second buffer layer BF2 may be disposed on the first buffer layer BF1 and the light blocking layers BML. The second buffer layer BF2 may include an inorganic layer that can prevent penetration of air or moisture. For example, the second buffer layer BF2 may include inorganic layers stacked on each other alternately.

The thin-film transistors TFT may be disposed on the second buffer layer BF2 and may constitute pixel circuits of pixels. For example, each of the thin-film transistors TFT may be a driving transistor or a switching transistor of a pixel circuit. Each of the thin-film transistors TFT may include a semiconductor region ACT, a source electrode SE, a drain electrode DE, and a gate electrode GE.

The semiconductor region ACT, the source electrode SE, and the drain electrode DE may be disposed on the second buffer layer BF2. The semiconductor region ACT, the source electrode SE, and the drain electrode DE may overlap a light blocking layer BML, e.g., in the thickness direction. The semiconductor region ACT may be overlapped by the gate electrode GE, e.g., in the thickness direction and may be insulated from the gate electrode GE by the gate insulating layer GI. The source electrode SE and the drain electrode DE may be formed by making the material of the semiconductor region ACT conductive.

The gate electrode GE may be disposed on the gate insulating layer GI. The gate electrode GE may overlap the semiconductor region ACT with the gate insulating layer GI interposed between them.

The gate insulating layer GI may be disposed on the semiconductor regions ACT, the source electrodes SE, the drain electrodes DE, and the second buffer layer BF2. The gate insulating layer GI may insulate the semiconductor regions ACT from the gate electrodes GE.

The first interlayer insulating layer ILD1 may be disposed on the gate electrodes GE and the gate insulating layer GI. The first interlayer insulating layer ILD1 may insulate the gate electrodes GE from the capacitor electrodes CPE.

The capacitor electrodes CPE may be disposed on the first interlayer insulating layer ILD1. The capacitor electrodes CPE may overlap the gate electrodes GE, e.g., in the thickness direction. The capacitor electrodes CPE and the gate electrodes GE may form capacitances.

The second interlayer insulating layer ILD2 may be disposed on the capacitor electrodes CPE and the first interlayer insulating layer ILD1. The second interlayer insulating layer ILD2 may insulate the capacitor electrodes CPE from the first connection electrodes CNE 1.

The first connection electrodes CNE1 may be disposed on the second interlayer insulating layer ILD2. The first connection electrodes CNE1 may electrically connect the drain electrodes DE of the thin-film transistors TFT to the second connection electrodes CNE2. The first connection electrodes CNF1 may be inserted into contact holes provided in the second interlayer insulating layer ILD2, the first interlayer insulating layer ILD1 and the gate insulating layer GI to contact the drain electrodes DE of the thin-film transistors TFT.

The first passivation layer PAS1 may be disposed on the first connection electrodes CNE1 and the second interlayer insulating layer ILD2. The first passivation layer PAS1 may protect the thin-film transistors TFT. The first passivation layer PAS1 may insulate the first connection electrodes CNE1 from the second connection electrodes CNE2.

The second connection electrodes CNE2 may be disposed on the first passivation layer PAS1. A second connection electrodes CNE2 may electrically connect a first connection electrode CNE1 to a first pixel electrode AE1 of a first light emitting element ED1. The second connection electrodes CNE2 may be inserted into contact holes provided in the first passivation layer PAS1 to contact the first connection electrodes CNE1.

The second passivation layer PAS2 may be disposed on the second connection electrodes CNE2 and the first passivation layer PAS 1. The second passivation layer PAS2 may insulate a second connection electrode CNE2 from the first pixel electrode AE1.

The light emitting element layer EML may be disposed on the thin-film transistor layer TFTL. The light emitting element layer EMI, may include first through third light emitting elements ED1 through ED3, residual patterns RP, a first insulating layer IL1, capping layers CAP, a bank BNK, first and second residual inorganic layers IOR1 and IOR2, first and second oxide layers OM1 and OM2, and first through third inorganic layers TL1 through TL3.

The display device 10 may include pixels arranged along rows and columns in the display area DA. The pixels may respectively include first through third emission areas EA1 through EA3 defined by the bank BNK or the pixel defining layer and may emit light having a peak wavelength (e.g., a predetermined or selectable peak wavelength) through the first through third emission areas EA1 through EA3. Each of the first through third emission areas EA1 through EA3 may be an area where light generated by a light emitting element of the display device 10 is emitted to the outside of the display device 10.

Each of the first through third emission areas EA1 through EA3 may emit light having a peak wavelength to the outside of the display device 10. The first emission area EA1 may emit light of a first color, the second emission area EA2 may emit light of a second color, and the third emission area EA3 may emit light of a third color. For example, the light of the first color may be red light having a peak wavelength of about 610 nm to about 650 nm, the light of the second color may be green light having a peak wavelength of about 510 nm to about 550 nm, and the light of the third color may be blue light having a peak wavelength of about 440 nm to about 480 nm. However, the disclosure is not limited thereto.

For example, the area of the third emission area EA3 may be larger than the area of the first emission area EA1, and the area of the first emission area EA1 may be larger than the area of the second emission area EA2. However, the disclosure is not limited thereto. In another example, the area of the first emission area EA1, the area of the second emission area EA2, and the area of the third emission area EA3 may be substantially the same.

The first light emitting element ED1 may be disposed on the thin-film transistor layer TFTL in the first emission area EA1. The first light emitting element ED1 may include the first pixel electrode AE1, a first light emitting layer EL1, and a first common electrode CE1. The second light emitting element ED2 may be disposed on the thin-film transistor layer TFTL in the second emission area EA2. The second light emitting element ED2 may include a second pixel electrode AE2, a second light emitting layer EL2, and a second common electrode CE2. The third light emitting element ED3 may be disposed on the thin-film transistor layer TFTL in the third emission area EA3. The third light emitting element ED3 may include a third pixel electrode AE3, a third light emitting layer EL3, and a third common electrode CE3.

The first through third pixel electrodes AE1 through AE3 may be disposed on the second passivation layer PAS2. Each of the first through third pixel electrodes AE1 through AE3 may be electrically connected to the drain electrode DE of a thin-film transistor TFT through the first and second connection electrodes CNE1 and CNE2. The first through third pixel electrodes AE1 through AE3 may be insulated from each other by the first insulating layer IL1. For example, the first through third pixel electrodes AE1 through AE3 may include at least one of silver (Ag), copper (Cu), aluminium (Al), nickel (Ni), and lanthanum (La). In another example, the first through third pixel electrodes AE1 through AE3 may include a material such as indium tin oxide (ITO), indium zinc oxide (IZO), or indium tin zinc oxide (ITZO). In another example, the first through third pixel electrodes AE1 through AE3 may have a stacked structure of ITO/Ag/ITO, ITO/Ag/IZO, or ITO/Ag/ITZO/IZO.

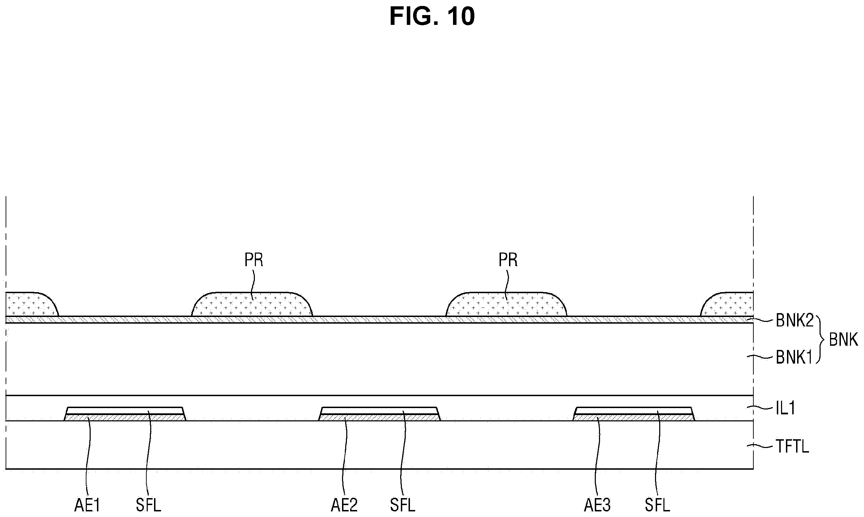

A residual pattern RP may be disposed on edges of each of the first through third pixel electrodes AE1 through AE3. The first insulating layer IL1 may not directly contact an upper surface of each of the first through third pixel electrodes AE1 through AE3 due to the residual pattern RP. The residual pattern RP may be formed as a result of removing a sacrificial layer SFL (see FIG. 10) disposed on each of the first through third pixel electrodes AE1 through AE3 in a manufacturing process of the display device 10.

The first insulating layer IL1 may be disposed on the second passivation layer PAS2 and the residual patterns RP. The first insulating layer IL1 may cover the edges of the first through third pixel electrodes AE1 through AE3 and the residual patterns RP and may partially expose the upper surfaces of the first through third pixel electrodes AE1 through AE3. For example, the first insulating layer IL1 may expose the first pixel electrode AE1 in the first emission area EA1, and the first light emitting layer EL1 may be directly disposed on the first pixel electrode AE1. The first insulating layer IL1 may include an inorganic insulating material. Examples of the first insulating layer IL1 may include, but are not limited to, at least one of a silicon nitride layer, a silicon oxynitride layer, a silicon oxide layer, a titanium oxide layer, an aluminium oxide layer, and an amorphous silicon layer.

The first through third light emitting layers EL1 through EL3 may be organic light emitting layers made of an organic material and may be formed on the first through third pixel electrodes AE1 through AE3 through a deposition process. For example, an organic material may be deposited in a direction inclined from an upper surface of the substrate SUB in a deposition process of the first through third light emitting layers EL1 through EL3.

The first light emitting layer EL1 may be directly disposed on the first pixel electrode AE1 in the first emission area EA1. A portion of the first light emitting layer EL1 may fill a space surrounded by the first pixel electrode AE1, a residual pattern RP and the first insulating layer IL1, and another portion of the first light emitting layer EL1 may cover upper and side surfaces of edges of the first insulating layer IL1. The second light emitting layer EL2 may be directly disposed on the second pixel electrode AE2 in the second emission area EA2. A portion of the second light emitting layer EL2 may fill a space surrounded by the second pixel electrode AE2, a residual pattern RP and the first insulating layer IL1, and another portion of the second light emitting layer EL2 may cover upper and side surfaces of edges of the first insulating layer IL1. The third light emitting layer EL3 may be directly disposed on the third pixel electrode AE3 in the third emission area EA3. A portion of the third light emitting layer EL3 may fill a space surrounded by the third pixel electrode AE3, a residual pattern RP and the first insulating layer IL1, and another portion of the third light emitting layer EL3 may cover upper and side surfaces of edges of the first insulating layer IL1.

The first common electrode CE1 may be disposed on the first light emitting layer EL1, the second common electrode CE2 may be disposed on the second light emitting layer EL2, and the third common electrode CE3 may be disposed on the third light emitting layer EL3. The first through third common electrodes CE1 through CE3 may include a transparent conductive material and transmit light generated from the first through third light emitting layers EL1 through EL3. The first through third common electrodes CE1 through CE3 may contact side surfaces of a first bank BNK1 and may be electrically connected by the first bank BNK1. For example, the first through third common electrodes CE1 through CE3 may receive a common voltage, a cathode voltage, or a low potential voltage.

The first pixel electrode AE1 may receive a voltage corresponding to a data voltage from a thin-film transistor TFT, and the first common electrode CE1 may receive a common voltage, a cathode voltage or a low potential voltage. In this case, since a potential difference may be formed between the first pixel electrode AE1 and the first common electrode CE1, holes may move to the first light emitting layer EL1 through a hole transporting layer, and electrons may move to the first light emitting layer EL1 through an electron transporting layer. Accordingly, the first light emitting layer EL1 may emit light.

The capping layers CAP may be disposed on the first through third common electrodes CE1 through CE3 in the first through third emission areas EA1 through EA3. The capping layers CAP may include an inorganic insulating material and may cover the first through third light emitting elements ED1 through ED3. The capping layers CAP may prevent the first through third light emitting elements ED1 through ED3 from being damaged by external air. For example, each of the capping layers CAP may include, but is not limited to, at least one of a silicon nitride layer, a silicon oxynitride layer, a silicon oxide layer, a titanium oxide layer, an aluminium oxide layer, and an amorphous silicon layer.

The bank BNK may be disposed on the first insulating layer IL1 to define the first through third emission areas EA1 through EA3. The bank BNK may surround the first through third emission areas EA1 through EA3 in plan view. The bank BNK may include first and second banks BNK1 and BNK2.

The first bank BNK1 may be disposed on the first insulating layer IL1, and the second bank BNK2 may be disposed on the first bank BNK1. The side surfaces of the first bank BNK1 may be recessed inward from side surfaces of the second bank BNK2. Since the side surfaces of the second bank BNK2 may protrude from the side surfaces of the first bank BNK1 toward the first emission area EA1, the second bank BNK2 may include protruding tips. Accordingly, an undercut structure may be formed under the tips of the second bank BNK2. A thickness of the first bank BNK1 may be greater than a thickness of the second bank BNK2.

The first and second banks BNK1 and BNK2 may include different metal materials. An etching rate of the first bank BNK1 and an etching rate of the second bank BNK2 may be different from each other. For example, the etching rate of the first bank BNK1 may be higher than that of the second bank BNK2 in a wet etching process, and the first bank BNK1 may be etched more than the second bank BNK2 in the process of forming the first through third emission areas EA1 through EA3. Therefore, the side shape of the first and second banks BNK1 and BNK2 may be determined by a difference in etching rate between the first and second banks BNK1 and BNK2. The first bank BNK1 may include a metal material having high electrical conductivity, and the second bank BNK2 may include a material having low reflectivity. For example, the first bank BNK1 may include aluminium (Al), and the second bank BNK2 may include titanium (Ti). However, the disclosure is not limited thereto.

The bank BNK may include openings that form the first through third emission areas EA1 through EA3 and may be overlapped by a light blocking member BM of the color filter layer CFL. The first bank BNK1 may electrically connect the first through third common electrodes CE1 through CE3 spaced apart from each other. The second bank BNK2 may include a material having low reflectivity to reduce reflection of external light.

The bank BNK may form the first through third emission areas EA1 through EA3 through a mask process, and the first through third light emitting layers EL1 through EL3 may be formed in the first through third emission areas EA1 through EA3, respectively. In the case that a mask process is performed, a structure for supporting a mask may be required, and an excessively wide non-display area NDA may be required to control distribution of the mask process. Therefore, if the mask process is minimized, a structure for supporting a mask can be omitted, and the area of the non-display area NDA for distribution control can be minimized.

The first through third light emitting elements ED1 through ED3 may be formed through deposition and etching processes rather than a mask process. Since the first and second banks BNK1 and BNK2 may include different metal materials, each inner wall of the bank BNK may have a tip structure. In the display device 10, different layers may be individually formed in the first through third emission areas EA1 through EA3 through a deposition process. For example, the first light emitting layer EL1 may be deposited in the first emission area EA1 by the tips formed on the inner walls of the bank BNK in the process of depositing an organic material without using a mask, and the organic material not disposed in the first emission area EA1 may be removed through an etching process.

An organic material for forming the first light emitting layer EL1 may be deposited on the entire surface of the display device 10, and the organic material of the first light emitting layer EL1 deposited in the second and third emission areas EA2 and EA3 may be removed. An organic material for forming the second light emitting layer EL2 may be deposited on the entire surface of the display device 10, and the organic material of the second light emitting layer EL2 deposited in the first and third emission areas EA1 and EA3 may be removed. An organic material for forming the third light emitting layer EL3 may be deposited on the entire surface of the display device 10, and the organic material of the third light emitting layer EL3 deposited in the first and second emission areas EA1 and EA2 may be removed. Therefore, in the display device 10, different organic materials can be formed in the first through third emission areas EA1 through EA3 through deposition and etching processes without using a mask process. The display device 10 can reduce manufacturing costs by omitting unnecessary processes and can minimize the area of the non-display area NDA.

In FIG. 5, the first inorganic layer TL1 may be disposed on the capping layer CAP of the first emission area EA1 to cover an upper surface of the capping layer CAP. The first inorganic layer TL1 may cover the side surfaces of the first bank BNK1 and lower and side surfaces of the tips of the second bank BNK2. The first inorganic layer TL1 may include an inorganic material to prevent oxygen or moisture from penetrating into the first light emitting element ED1. The first inorganic layer TL1 may be an inorganic encapsulation layer. For example, the first inorganic layer TL1 may include, but is not limited to, at least one of a silicon nitride layer, a silicon oxynitride layer, a silicon oxide layer, a titanium oxide layer, an aluminium oxide layer, and an amorphous silicon layer.

In FIG. 6, the first residual inorganic layer IOR1 may be disposed on the lower surfaces of the tips of the second bank BNK2 adjacent to the second emission area EA2. The first residual inorganic layer IOR1 may be formed in the case that the material that forms the first inorganic layer TL1 is not completely removed from the lower surfaces of the tips of the second bank BNK2 in the process of forming the first inorganic layer TL1. Therefore, the first residual inorganic layer IOR1 and the first inorganic layer TL1 may include a same material. A thickness of the first residual inorganic layer IOR1 may be smaller than the thickness of the second bank BNK2.

The first oxide layer OM1 may cover a lower surface of the first residual inorganic layer IOR1. The first oxide layer OM1 may be formed by oxidation of the surface of the first residual inorganic layer IOR1 in the process of etching an organic material, a metal material, and an inorganic material not disposed in the first emission area EA1. Here, the organic material not disposed in the first emission area EA1 may be the material that forms the first light emitting layer EL1, the metal material not disposed in the first emission area EA1 may be the material that forms the first common electrode CE1, and the inorganic material not disposed in the first emission area EA1 may be the material that forms the capping layer CAP.

The first residual inorganic layer IOR1 and the first oxide layer OM1 disposed on the lower surfaces of the tips of the second bank BNK2 adjacent to the second emission area EA2 may increase a thickness of a tip structure that forms the second light emitting element ED2. Therefore, since the first residual inorganic layer IOR1 and the first oxide layer OM1 may not be disposed on the lower surfaces of the tips of the second bank BNK2 adjacent to the first emission area EA1, the thickness of the tip structure that forms the second light emitting element ED2 may be greater than a thickness of a tip structure that forms the first light emitting element ED1. Even if the thickness of the tip structure that forms the second light emitting element ED2 increases, the reliability of the second light emitting element ED2 can be secured.

The second inorganic layer TL2 may be disposed on the capping layer CAP of the second emission area EA2 to cover an upper surface of the capping layer CAP. The second inorganic layer TL2 may cover the side surfaces of the first bank BNK1, lower and side surfaces of the first oxide layer OM1, and the side surfaces of the tips of the second bank BNK2. The second inorganic layer TL2 may include an inorganic material to prevent oxygen or moisture from penetrating into the second light emitting element ED2. The second inorganic layer TL2 may be an inorganic encapsulation layer. For example, the second inorganic layer TL2 may be made of various materials, e.g., any of the materials that may be used to form the first inorganic layer TL1 as discussed herein.

In FIG. 7, the first residual inorganic layer IOR1 may be disposed on the lower surfaces of the tips of the second bank BNK2 adjacent to the third emission area EA3. The first residual inorganic layer IOR1 may be formed in the case that the material that forms the first inorganic layer TL1 is not completely removed from the lower surfaces of the tips of the second bank BNK2 in the process of forming the first inorganic layer TL1. Therefore, the first residual inorganic layer IOR1 and the first inorganic layer TL1 may include a same material. The thickness of the first residual inorganic layer IOR1 may be smaller than the thickness of the second bank BNK2.

The first oxide layer OM1 may cover the lower surface of the first residual inorganic layer IOR1. The first oxide layer OM1 may be formed by oxidation of the surface of the first residual inorganic layer IOR1 in the process of etching the organic material, the metal material, and the inorganic material not disposed in the first emission area EA1.

The second residual inorganic layer IOR2 may be disposed on a lower surface of the first oxide layer OM1 adjacent to the third emission area EA3. The second residual inorganic layer IOR2 may be formed in the case that the material that forms the second inorganic layer TL2 is not completely removed from the lower surface of the first oxide layer OM1 in the process of forming the second inorganic layer TL2. Therefore, the second residual inorganic layer IOR2 and the second inorganic layer TL2 may include a same material. A thickness of the second residual inorganic layer IOR2 may be smaller than the thickness of the second bank BNK2.

The second oxide layer OM2 may cover a lower surface of the second residual inorganic layer IOR2. The second oxide layer OM2 may be formed by oxidation of the surface of the second residual inorganic layer IOR2 in the process of etching an organic material, a metal material, and an inorganic material not disposed in the second emission area EA2. Here, the organic material not disposed in the second emission area EA2 may be the material that forms the second light emitting layer EL2, the metal material not disposed in the second emission area EA2 may be the material that forms the second common electrode CE2, and the inorganic material not disposed in the second emission area EA2 may be the material that forms the capping layer CAP.

The first residual inorganic layer IOR1, the first oxide layer OM1, the second residual inorganic layer IOR2, and the second oxide layer OM2 formed on the lower surfaces of the tips of the second bank BNK2 adjacent to the third emission area EA3 may increase a thickness of a tip structure that forms the third light emitting element ED3. Therefore, since the second residual inorganic layer IOR2 and the second oxide layer OM2 may not be disposed under the tips of the second bank BNK2 adjacent to the second emission area EA2, the thickness of the tip structure that forms the third light emitting element ED3 may be greater than the thickness of the tip structure that forms the second light emitting element ED2. Even if the thickness of the tip structure that forms the third light emitting element ED3 increases, the reliability of the third light emitting element ED3 can be secured.

The third inorganic layer TL3 may be disposed on the capping layer CAP of the third emission area EA3 to cover an upper surface of the capping layer CAP. The third inorganic layer TL3 may cover the side surfaces of the first bank BNK1, lower and side surfaces of the second oxide layer OM2, the side surfaces of the first oxide layer OM1, and the side surfaces of the tips of the second bank BNK2. The third inorganic layer TL3 may include an inorganic material to prevent oxygen or moisture from penetrating into the third light emitting element ED3. The third inorganic layer TL3 may be an inorganic encapsulation layer. For example, the third inorganic layer TL3 may be made of various materials, e.g., any of the materials that may be used to form the first inorganic layer TL1 as discussed herein.

The encapsulation layer TFEL may be disposed on the first through third inorganic layers TL1 through TL3 to cover the light emitting element layer EML. The encapsulation layer TFEL may include first and second encapsulation layers TFE1 and TFE2.

The first encapsulation layer TFE1 may be disposed on the first through third inorganic layers TL1 through TL3. The first encapsulation layer TFE1 may cover the second bank BNK2 exposed between the first through third inorganic layers TL1 through TL3. The first encapsulation layer TFE1 may be disposed on the first through third inorganic layers TL1 through TL3 to planarize an upper end of the light emitting element layer EML. The first encapsulation layer TFE1 may include an organic material to protect the light emitting element layer EML from foreign substances such as dust. For example, the first encapsulation layer TFE1 may include an organic layer such as acryl resin, epoxy resin, phenolic resin, polyamide resin, or polyimide resin. The first encapsulation layer TFE1 may be formed by curing a monomer or applying a polymer.

The second encapsulation layer TFE2 may be disposed on the first encapsulation layer TFE1. The second encapsulation layer TFE2 may include an inorganic material to prevent oxygen or moisture from penetrating into the light emitting element layer EML. For example, the second encapsulation layer TFE2 may include, but is not limited to, at least one of a silicon nitride layer, a silicon oxynitride layer, a silicon oxide layer, a titanium oxide layer, an aluminium oxide layer, and an amorphous silicon layer.

The touch sensing unit TSU may be disposed on the encapsulation layer TFEL. The touch sensing unit TSU may include a third buffer layer BF3, a bridge electrode BRG, a second insulating layer IL2, touch electrodes TE, and a third insulating layer IL3.

The third buffer layer BF3 may be disposed on the encapsulation layer TFEL. The third buffer layer BF3 may have insulating and optical functions. The third buffer layer BF3 may include at least one inorganic layer. Optionally, the third buffer layer BF3 may be omitted.

The bridge electrode BRG may be disposed on the third buffer layer BF3. The bridge electrode BRG may be disposed on a different layer from the touch electrodes TE and may electrically connect adjacent touch electrodes TE.

The second insulating layer IL2 may be disposed on the bridge electrode BRG and the third buffer layer BF3. The second insulating layer IL2 may have insulating and optical functions. For example, the second insulating layer IL2 may include, but is not limited to, at least one of a silicon nitride layer, a silicon oxynitride layer, a silicon oxide layer, a titanium oxide layer, an aluminium oxide layer, and an amorphous silicon layer.

The touch electrodes TE may be disposed on the second insulating layer IL2. The touch electrodes TE may include a driving electrode and a sensing electrode and may sense a change in mutual capacitance between the driving electrode and the sensing electrode. The touch electrodes TE may not overlap the first through third emission areas EA1 through EA3. For example, each of the touch electrodes TE may be a single layer of molybdenum (Mo), titanium (Ti), copper (Cu), aluminium (Al) or indium tin oxide (ITO) or may be a stacked structure (Ti/Al/Ti) of aluminium and titanium, a stacked structure (ITO/Al/ITO) of aluminium and indium tin oxide, an APC alloy, or a stacked structure (ITO/APC/ITO) of an APC alloy and indium tin oxide.

The third insulating layer IL3 may be disposed on the touch electrodes TE and the second insulating layer IL2. The third insulating layer IL3 may have insulating and optical functions. The third insulating layer IL3 may be made of various materials, e.g., any of the materials that may be used to form the second insulating layer IL2 as discussed herein.

The color filter layer CFL may be disposed on the touch sensing unit TSU. The color filter layer CFL may include the light blocking member BM, first through third color filters CF1 through CF3, and a planarization layer OC.

The light blocking member BM may be disposed on the third insulating layer IL3 to surround first through third optical areas OPT1 through OPT3. The light blocking member BM may overlap the touch electrodes TE. The light blocking member BM may include a light absorbing material to prevent reflection of light. For example, the light blocking member BM may include an inorganic black pigment, an organic black pigment, or an organic blue pigment. The inorganic black pigment may be a metal oxide such as carbon black or titanium black, the organic black pigment may include at least one of lactam black, perylene black and aniline black, and the organic blue pigment may be C.I pigment blue. However, the disclosure is not limited thereto. The light blocking member BM may prevent color mixing by preventing intrusion of visible light between the first through third emission areas EA1 through EA3, thereby improving a color gamut of the display device 10.

The first through third color filters CF1 through CF3 may be disposed on the third insulating layer IL3 to correspond to the first through third emission areas EA1 through EA3, respectively.

The first color filter CF1 may be disposed on the third insulating layer IL3 in the first emission area EA1. The first color filter CF1 may be surrounded by the light blocking member BM in plan view. Edges of the first color filter CF1 may partially cover an upper surface of the light blocking member BM, but the disclosure is not limited thereto. The first color filter CF1 may selectively transmit light of the first color (e.g., red light) and block or absorb light of the second color (e.g., green light) and light of the third color (e.g., blue light). For example, the first color filter CF1 may be a red color filter and may include a red colorant.

The second color filter CF2 may be disposed on the third insulating layer IL3 in the second emission area EA2. The second color filter CF2 may be surrounded by the light blocking member BM in plan view. Edges of the second color filter CF2 may partially cover the upper surface of the light blocking member BM, but the disclosure is not limited thereto. The second color filter CF2 may selectively transmit light of the second color (e.g., green light) and block or absorb light of the first color (e.g., red light) and light of the third color (e.g., blue light). For example, the second color filter CF2 may be a green color filter and may include a green colorant.

The third color filter CF3 may be disposed on the third insulating layer IL3 in the third emission area EA3. The third color filter CF3 may be surrounded by the light blocking member BM in plan view. Edges of the third color filter CF3 may partially cover the upper surface of the light blocking member BM, but the disclosure is not limited thereto. The third color filter CF3 may selectively transmit light of the third color (e.g., blue light) and block or absorb light of the first color (e.g., red light) and light of the second color (e.g., green light). For example, the third color filter CF3 may be a blue color filter and may include a blue colorant.

The first through third color filters CF1 through CF3 may absorb a part of light coming from the outside of the display device 10, thereby reducing reflected light due to the external light. Therefore, the first through third color filters CF1 through CF3 can prevent color distortion due to reflection of external light.

The planarization layer OC may be disposed on the light blocking member BM and the first through third color filters CF1 through CF3. The planarization layer OC may planarize an upper end of the color filter layer CFL. For example, the planarization layer OC may include an organic insulating material.

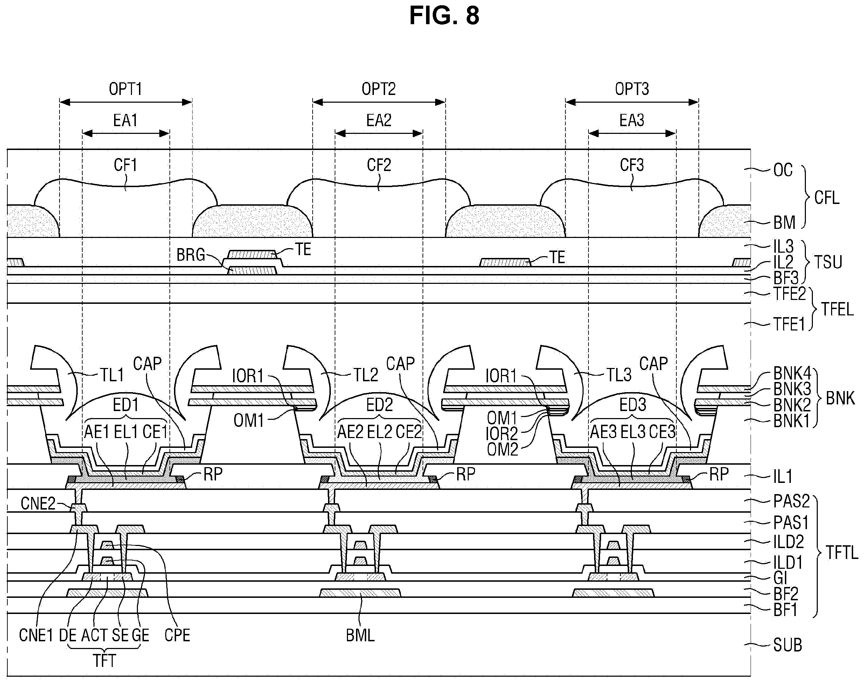

FIG. 8 is a schematic cross-sectional view illustrating pixels of a display device according to an embodiment. The display device of FIG. 8 is different from the display device of FIG. 4 in the configuration of a bank BNK. The same elements as those described above will be briefly described or will not be described.

Referring to FIG. 8, a display panel 100 may include a display unit DU, a touch sensing unit TSU, and a color filter layer CFL. The display unit DU may include a substrate SUB, a thin-film transistor layer TFTL, a light emitting element layer EML, and an encapsulation layer TFEL.

The light emitting element layer EML may include first through third light emitting elements ED1 through ED3, residual patterns RP, a first insulating layer IL1, capping layers CAP, the bank BNK, first and second residual inorganic layers IOR1 and IOR2, first and second oxide layers OM1 and OM2, and first through third inorganic layers TL1 through TL3.

The bank BNK may be disposed on the first insulating layer IL1 to define first through third emission areas EA1 through EA3. The bank BNK may surround the first through third emission areas EA1 through EA3 in plan view. The bank BNK may include first through fourth banks BNK1 through BNK4.

The first bank BNK1 may be disposed on the first insulating layer IL1, the second bank BNK2 may be disposed on the first bank BNK1, the third bank BNK3 may be disposed on the second bank BNK2, and the fourth bank BNK4 may be disposed on the third bank BNK3. Side surfaces of the first and third banks BNK1 and BNK3 may be recessed inward from side surfaces of the second and fourth banks BNK2 and BNK4. Since the side surfaces of the second bank BNK2 may protrude from the side surfaces of the first and third banks BNK1 and BNK3 toward the first emission area EA1, the second bank BNK2 may include protruding tips. Since the side surfaces of the fourth bank BNK4 may protrude from the side surfaces of the third bank BNK3 toward the first emission area EA1, the fourth bank BNK4 may include protruding tips. Accordingly, an undercut structure may be formed under the tips of each of the second and fourth banks BNK2 and BNK4. A thickness of the first bank BNK1 may be greater than a thickness of each of the second through fourth banks BNK2 through BNK4.

The first and second banks BNK1 and BNK2 may include different metal materials. The third and fourth banks BNK3 and BNK4 may include different metal materials. An etching rate of the first bank BNK1 and an etching rate of the second bank BNK2 may be different from each other. An etching rate of the third bank BNK3 and an etching rate of the fourth bank BNK4 may be different from each other. For example, the etching rate of each of the first and third banks BNK1 and BNK3 may be higher than that of each of the second and fourth banks BNK2 and BNK4 in a wet etching process, and the first and third banks BNK1 and BNK3 may be etched more than the second and fourth banks BNK2 and BNK4 in the process of forming the first through third emission areas EA1 through EA3. Therefore, the side shape of the first through fourth banks BNK1 through BNK4 may be determined by a difference in etching rate between the first through fourth banks BNK1 through BNK4. The first and third banks BNK1 and BNK3 may include a metal material having high electrical conductivity, and the second and fourth banks BNK2 and BNK4 may include a material having low reflectivity. For example, the first and third banks BNK1 and BNK3 may include aluminium (Al), and the second and fourth banks BNK2 and BNK4 may include titanium (Ti). However, the disclosure is not limited thereto.

The bank BNK may include openings that form the first through third emission areas EA1 through EA3 and may be overlapped by a light blocking member BM of the color filter layer CFL. The first bank BNK1 may electrically connect first through third common electrodes CE1 through CE3 spaced apart from each other. The fourth bank BNK4 may include a material having low reflectivity to reduce reflection of external light.

The bank BNK may form the first through third emission areas EA1 through EA3 through a mask process, and first through third light emitting layers EL1 through EL3 may be formed in the first through third emission areas EA1 through EA3, respectively. In the case that a mask process is performed, a structure for supporting a mask may be required, and an excessively wide non-display area NDA may be required to control distribution of the mask process. Therefore, if the mask process is minimized, a structure for supporting a mask can be omitted, and the area of the non-display area NDA for distribution control can be minimized.

The first through third light emitting elements ED1 through ED3 may be formed through deposition and etching processes rather than a mask process. Since the first and third banks BNK1 and BNK3 may include a different metal material from the second and fourth banks BNK2 and BNK4, each inner wall of the bank BNK may have a two-tip structure. In the display device 10, different layers may be individually formed in the first through third emission areas EA1 through EA3 through a deposition process. For example, the first light emitting layer EL1 may be deposited in the first emission area EA1 by two tips formed on each inner wall of the bank BNK in the process of depositing an organic material without using a mask, and the organic material not disposed in the first emission area EA1 may be removed through an etching process.

In the display device 10 including the first through fourth banks BNK1 through BNK4, the first through third light emitting elements ED1 through ED3 can be easily formed through deposition and etching processes using the two-tip structure, and permeation of moisture into the first through third light emitting elements ED1 through ED3 can be prevented.

The first inorganic layer TL1 may be disposed on the capping layer CAP of the first emission area EA1 to cover an upper surface of the capping layer CAP. The first inorganic layer TL1 may cover the side surfaces of the first and third banks BNK1 and BNK3 and lower and side surfaces of the tips of each of the second and fourth banks BNK2 and BNK4. The first inorganic layer TL1 may include an inorganic material to prevent oxygen or moisture from penetrating into the first light emitting element ED1. The first inorganic layer TL1 may be an inorganic encapsulation layer. For example, the first inorganic layer TL1 may include, but is not limited to, at least one of a silicon nitride layer, a silicon oxynitride layer, a silicon oxide layer, a titanium oxide layer, an aluminium oxide layer, and an amorphous silicon layer.

The first residual inorganic layer IOR1 may be disposed on the lower surfaces of the tips of the second bank BNK2 adjacent to each of the second and third emission areas EA2 and EA3. The first residual inorganic layer IOR1 may be formed in the case that the material that forms the first inorganic layer TL1 is not completely removed from the lower surfaces of the tips of the second bank BNK2 in the process of forming the first inorganic layer TL1. Therefore, the first residual inorganic layer IOR1 may include the same material as the first inorganic layer TL1. A thickness of the first residual inorganic layer IOR1 may be smaller than the thickness of the second bank BNK2.

The first oxide layer OM1 may cover a lower surface of the first residual inorganic layer IOR1. The first oxide layer OM1 may be formed by oxidation of the surface of the first residual inorganic layer IOR1 in the process of etching an organic material, a metal material, and an inorganic material not disposed in the first emission area EA1. Here, the organic material not disposed in the first emission area EA1 may be the material that forms the first light emitting layer EL1, the metal material not disposed in the first emission area EA1 may be the material that forms the first common electrode CE1, and the inorganic material not disposed in the first emission area EA1 may be the material that forms the capping layer CAP.

Optionally, the first residual inorganic layer IOR1 and the first oxide layer OM1 may be additionally disposed on the lower surfaces of the tips of the fourth bank BNK4 adjacent to the second emission area EA2, but the disclosure is not limited thereto.

The first residual inorganic layer IOR1 and the first oxide layer OM1 disposed on the lower surfaces of the tips of the second bank BNK2 adjacent to the second emission area EA2 may increase a thickness of a tip structure that forms the second light emitting element ED2. Therefore, since the first residual inorganic layer IOR1 and the first oxide layer OM1 may not be disposed on the lower surfaces of the tips of the second bank BNK2 adjacent to the first emission area EA1, the thickness of the tip structure that forms the second light emitting element ED2 may be greater than a thickness of a tip structure that forms the first light emitting element ED1. Even if the thickness of the tip structure that forms the second light emitting element ED2 increases, the reliability of the second light emitting element ED2 can be secured.

The second inorganic layer TL2 may be disposed on the capping layer CAP of the second emission area EA2 to cover an upper surface of the capping layer CAP. The second inorganic layer TL2 may cover the side surfaces of the first and third banks BNK1 and BNK3, lower and side surfaces of the first oxide layer OM1, the side surfaces of the tips of the second bank BNK2, and the lower and side surfaces of the tips of the fourth bank BNK4. The second inorganic layer TL2 may include an inorganic material to prevent oxygen or moisture from penetrating into the second light emitting element ED2. The second inorganic layer TL2 may be an inorganic encapsulation layer. For example, the second inorganic layer TL2 may be made of various materials, e.g., any of the materials that may be used to form the first inorganic layer TL1 as discussed herein.

The second residual inorganic layer IOR2 may be disposed on the lower surface of the first oxide layer OM1 adjacent to the third emission area EA3. The second residual inorganic layer IOR2 may be formed in the case that the material that forms the second inorganic layer TL2 is not completely removed from the lower surface of the first oxide layer OM1 in the process of forming the second inorganic layer TL2. Therefore, the second residual inorganic layer IOR2 and the second inorganic layer TL2 may include a same material. A thickness of the second residual inorganic layer IOR2 may be smaller than the thickness of the second bank BNK2.

The second oxide layer OM2 may cover a lower surface of the second residual inorganic layer IOR2. The second oxide layer OM2 may be formed by oxidation of the surface of the second residual inorganic layer IOR2 in the process of etching an organic material, a metal material, and an inorganic material not disposed in the second emission area EA2. Here, the organic material not disposed in the second emission area EA2 may be the material that forms the second light emitting layer EL2, the metal material not disposed in the second emission area EA2 may be the material that forms the second common electrode CE2, and the inorganic material not disposed in the second emission area EA2 may be the material that forms the capping layer CAP.

Optionally, the second residual inorganic layer IOR2 and the second oxide layer OM2 may be additionally disposed on the lower surfaces of the tips of the fourth bank BNK4 adjacent to the third emission area EA3, but the disclosure is not limited thereto.

The first residual inorganic layer IOR1, the first oxide layer OM1, the second residual inorganic layer IOR2, and the second oxide layer OM2 disposed on the lower surfaces of the tips of the second bank BNK2 adjacent to the third emission area EA3 may increase a thickness of a tip structure that forms the third light emitting element ED3. Therefore, since the second residual inorganic layer IOR2 and the second oxide layer OM2 may not be disposed under the tips of the second bank BNK2 adjacent to the second emission area EA2, the thickness of the tip structure that forms the third light emitting element ED3 may be greater than the thickness of the tip structure that forms the second light emitting element ED2. Even if the thickness of the tip structure that forms the third light emitting element ED3 increases, the reliability of the third light emitting element ED3 can be secured.

The third inorganic layer TL3 may be disposed on the capping layer CAP of the third emission area EA3 to cover an upper surface of the capping layer CAP. The third inorganic layer TL3 may cover the side surfaces of the first and third banks BNK1 and BNK3, lower and side surfaces of the second oxide layer OM2, the side surfaces of the first oxide layer OM1, the side surfaces of the tips of the second bank BNK2, and the lower and side surfaces of the tips of the fourth bank BNK4. The third inorganic layer TL3 may include an inorganic material to prevent oxygen or moisture from penetrating into the third light emitting element ED3. The third inorganic layer TL3 may be an inorganic encapsulation layer. For example, the third inorganic layer TL3 may be made of various materials, e.g., any of the materials that may be used to form the first inorganic layer TL1 as discussed herein.

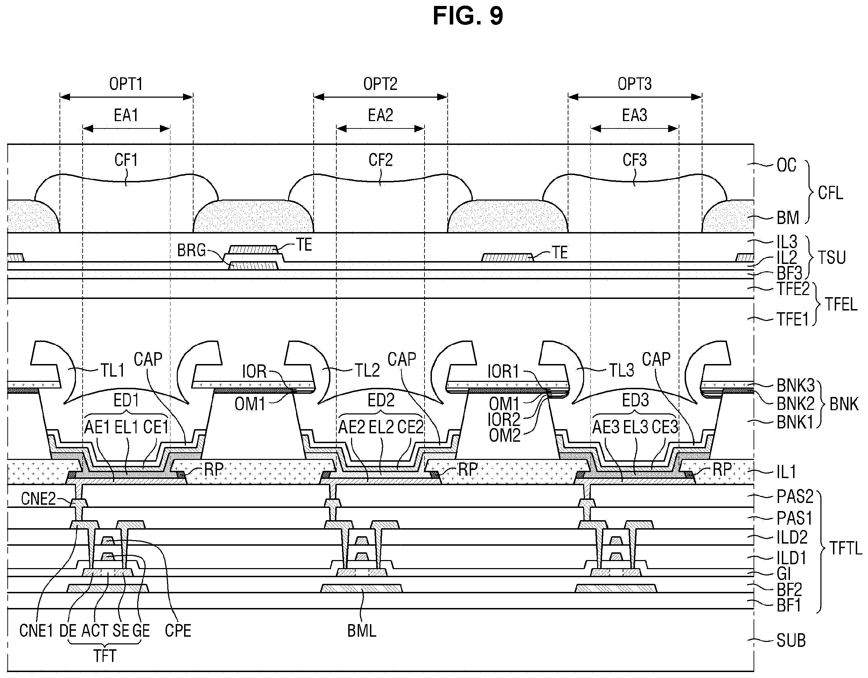

FIG. 9 is a schematic cross-sectional view illustrating pixels of a display device according to an embodiment. The display device of FIG. 9 is different from the display device of FIG. 4 or 8 in the configuration of a bank BNK. The same elements as those described above will be briefly described or will not be described.

Referring to FIG. 9, a display panel 100 may include a display unit DU, a touch sensing unit TSU, and a color filter layer CFL. The display unit DU may include a substrate SUB, a thin-film transistor layer TFTL, a light emitting element layer EML, and an encapsulation layer TFEL.

The light emitting element layer EML may include first through third light emitting elements ED1 through ED3, residual patterns RP, a first insulating layer IL1, capping layers CAP, the bank BNK, first and second residual inorganic layers IOR1 and IOR2, first and second oxide layers OM1 and OM2, and first through third inorganic layers TL1 through TL3.

A residual pattern RP may be disposed on edges of each of first through third pixel electrodes AE1 through AE3. The first insulating layer IL1 may not directly contact an upper surface of each of the first through third pixel electrodes AE1 through AE3 due to the residual pattern RP. The residual pattern RP may be formed as a result of removing a sacrificial layer SFL (see FIG. 10) disposed on each of the first through third pixel electrodes AE1 through AE3 in a manufacturing process of the display device 10.

The first insulating layer IL1 may be disposed on a second passivation layer PAS2 and the residual patterns RP. The first insulating layer IL1 may cover the edges of the first through third pixel electrodes AE1 through AE3 and the residual patterns RP and may partially expose the upper surfaces of the first through third pixel electrodes AE1 through AE3. For example, the first insulating layer IL1 may expose the first pixel electrode AE1 in a first emission area EA1, and a first light emitting layer EL1 may be directly disposed on the first pixel electrode AE1. The first insulating layer IL1 may include an inorganic insulating material. The first insulating layer IL1 may include, but is not limited to, at least one of a silicon nitride layer, a silicon oxynitride layer, a silicon oxide layer, a titanium oxide layer, an aluminium oxide layer, and an amorphous silicon layer.

The bank BNK may be disposed on the first insulating layer IL1 to define first through third emission areas EA1 through EA3. The bank BNK may surround the first through third emission areas EA1 through EA3 in plan view. The bank BNK may include first through third banks BNK1 through BNK3.

The first bank BNK1 may be disposed on the first insulating layer IL1, the second bank BNK2 may be disposed on the first bank BNK1, and the third bank BNK3 may be disposed on the second bank BNK2. Side surfaces of the first and second banks BNK1 and BNK2 may be recessed inward from side surfaces of the third bank BNK3. Since the side surfaces of the third bank BNK3 may protrude from the side surfaces of the first and second banks BNK1 and BNK2 toward the first emission area EA1, the third bank BNK3 may include protruding tips. Accordingly, an undercut structure may be formed under the tips of the third bank BNK3. A thickness of the first bank BNK1 may be greater than a thickness of each of the second and third banks BNK2 and BNK3.

The first through third banks BNK1 through BNK3 may include different materials. Etching rates of the first and second banks BNK1 and BNK2 may be different from an etching rate of the third bank BNK3. For example, the etching rate of each of the first and second banks BNK1 and BNK2 may be higher than that of the third bank BNK3 in a wet etching process, and the first and second banks BNK1 and BNK2 may be etched more than the third bank BNK3 in the process of forming the first through third emission areas EA1 through EA3. Therefore, the side shape of the first through third banks BNK1 through BNK3 may be determined by a difference in etching rate between the first through third banks BNK1 through BNK3. The first bank BNK1 may include a metal material having high electrical conductivity, the second bank BNK2 may include a material having a higher etching rate than that of the third bank BNK3, and the third bank BNK3 may include a material having low reflectivity. For example, the first bank BNK1 may include aluminium (Al), the second bank BNK2 and the residual patterns RP may include a same material, and the third bank BNK3 may include the same material as the first insulating layer II,1. However, the disclosure is not limited thereto.

The bank BNK may include openings that form the first through third emission areas EA1 through EA3 and may be overlapped by a light blocking member BM of the color filter layer CFL. The first bank BNK1 may electrically connect first through third common electrodes CE1 through CE3 spaced apart from each other. The third bank BNK3 may include a material having low reflectivity to reduce reflection of external light.

The bank BNK may form the first through third emission areas EA1 through EA3 through a mask process, and first through third light emitting layers EL1 through EL3 may be formed in the first through third emission areas EA1 through EA3, respectively. In the case that a mask process is performed, a structure for supporting a mask may be required, and an excessively wide non-display area NDA may be required to control distribution of the mask process. Therefore, if the mask process is minimized, a structure for supporting a mask can be omitted, and the area of the non-display area NDA for distribution control can be minimized.

The first through third light emitting elements ED1 through ED3 may be formed through deposition and etching processes rather than a mask process. Since the first through third banks BNK1 through BNK3 may include different materials, each inner wall of the bank BNK may have a tip structure. In the display device 10, different layers may be individually formed in the first through third emission areas EA1 through EA3 through a deposition process. For example, the first light emitting layer EL1 may be deposited in the first emission area EA1 by the tips formed on the inner walls of the bank BNK in the process of depositing an organic material without using a mask, and the organic material not disposed in the first emission area EA1 may be removed through an etching process.

The first inorganic layer TL1 may be disposed on the capping layer CAP of the first emission area EA1 to cover an upper surface of the capping layer CAP. The first inorganic layer TL1 may cover the side surfaces of the first and second banks BNK1 and BNK2 and lower and side surfaces of the tips of the third bank BNK3. The first inorganic layer TL1 may include an inorganic material to prevent oxygen or moisture from penetrating into the first light emitting element ED1. The first inorganic layer TL1 may be an inorganic encapsulation layer. For example, the first inorganic layer TL1 may include, but is not limited to, at least one of a silicon nitride layer, a silicon oxynitride layer, a silicon oxide layer, a titanium oxide layer, an aluminium oxide layer, and an amorphous silicon layer.

The first residual inorganic layer IOR1 may be disposed on the lower surfaces of the tips of the third bank BNK3 adjacent to each of the second and third emission areas EA2 and EA3. The first residual inorganic layer IOR1 may be formed in the case that the material that forms the first inorganic layer TL1 is not completely removed from the lower surfaces of the tips of the third bank BNK3 in the process of forming the first inorganic layer TL1. Therefore, the first residual inorganic layer IOR1 may include the same material as the first inorganic layer TL1. A thickness of the first residual inorganic layer IOR1 may be smaller than the thickness of the third bank BNK3.

The first oxide layer OM1 may cover a lower surface of the first residual inorganic layer IOR1. The first oxide layer OM1 may be formed by oxidation of the surface of the first residual inorganic layer IOR1 in the process of etching an organic material, a metal material, and an inorganic material not disposed in the first emission area EA1. Here, the organic material not disposed in the first emission area EA1 may be the material that forms the first light emitting layer EL1, the metal material not disposed in the first emission area EA1 may be the material that forms the first common electrode CE1, and the inorganic material not disposed in the first emission area EA1 may be the material that forms the capping layer CAP.

The first residual inorganic layer IOR1 and the first oxide layer OM1 disposed on the lower surfaces of the tips of the third bank BNK3 adjacent to the second emission area EA2 may increase a thickness of a tip structure that forms the second light emitting element

ED2. Therefore, since the first residual inorganic layer IOR1 and the first oxide layer OM1 may not be disposed on the lower surfaces of the tips of the third bank BNK3 adjacent to the first emission area EA1, the thickness of the tip structure that forms the second light emitting element ED2 may be greater than a thickness of a tip structure that forms the first light emitting element ED1. Even if the thickness of the tip structure that forms the second light emitting element ED2 increases, the reliability of the second light emitting element ED2 can be secured.

The second inorganic layer TL2 may be disposed on the capping layer CAP of the second emission area EA2 to cover an upper surface of the capping layer CAP. The second inorganic layer TL2 may cover the side surfaces of the first and second banks BNK1 and BNK2, lower and side surfaces of the first oxide layer OM1, and the side surfaces of the tips of the third bank BNK3. The second inorganic layer TL2 may include an inorganic material to prevent oxygen or moisture from penetrating into the second light emitting element ED2. The second inorganic layer TL2 may be an inorganic encapsulation layer. For example, the second inorganic layer TL2 may be made of various materials, e.g., any of the materials that may be used to form the first inorganic layer TL1 as discussed herein.

The second residual inorganic layer IOR2 may be disposed on the lower surface of the first oxide layer OM1 adjacent to the third emission area EA3. The second residual inorganic layer IOR2 may be formed in the case that the material that forms the second inorganic layer TL2 is not completely removed from the lower surface of the first oxide layer OM1 in the process of forming the second inorganic layer TL2. Therefore, the second residual inorganic layer IOR2 may include the same material as the second inorganic layer TL2. A thickness of the second residual inorganic layer IOR2 may be smaller than the thickness of the third bank BNK3.

The second oxide layer OM2 may cover a lower surface of the second residual inorganic layer IOR2. The second oxide layer OM2 may be formed by oxidation of the surface of the second residual inorganic layer IOR2 in the process of etching an organic material, a metal material, and an inorganic material not disposed in the second emission area EA2. Here, the organic material not disposed in the second emission area EA2 may be the material that forms the second light emitting layer EL2, the metal material not disposed in the second emission area EA2 may be the material that forms the second common electrode CE2, and the inorganic material not disposed in the second emission area EA2 may be the material that forms the capping layer CAP.

The first residual inorganic layer IOR1, the first oxide layer OM1, the second residual inorganic layer IOR2, and the second oxide layer OM2 disposed on the lower surfaces of the tips of the third bank BNK3 adjacent to the third emission area EA3 may increase a thickness of a tip structure that forms the third light emitting element ED3. Therefore, since the second residual inorganic layer IOR2 and the second oxide layer OM2 may not be disposed under the tips of the third bank BNK3 adjacent to the second emission area EA2, the thickness of the tip structure that forms the third light emitting element ED3 may be greater than the thickness of the tip structure that forms the second light emitting element ED2. Even if the thickness of the tip structure that forms the third light emitting element ED3 increases, the reliability of the third light emitting element ED3 can be secured.

The third inorganic layer TL3 may be disposed on the capping layer CAP of the third emission area EA3 to cover an upper surface of the capping layer CAP. The third inorganic layer TL3 may cover the side surfaces of the first and second banks BNK1 and BNK2, lower and side surfaces of the second oxide layer OM2, the side surfaces of the first oxide layer OM1, and the side surfaces of the tips of the third bank BNK3. The third inorganic layer TL3 may include an inorganic material to prevent oxygen or moisture from penetrating into the third light emitting element ED3. The third inorganic layer TL3 may be an inorganic encapsulation layer. For example, the third inorganic layer TL3 may be made of various materials, e.g., any of the materials discussed herein with respect to the first inorganic layer TL1.

FIGS. 10 through 20 are schematic cross-sectional views illustrating a process of manufacturing a display device according to an embodiment.

In FIG. 10, first through third pixel electrodes AE1 through AE3 may be spaced apart from each other on a thin-film transistor layer TFTL. The first through third pixel electrodes AE1 through AE3 may include at least one of silver (Ag), copper (Cu), aluminium (Al), nickel (Ni), and lanthanum (La). In another example, the first through third pixel electrodes AE1 through AE3 may include a material such as indium tin oxide (ITO), indium zinc oxide (IZO), or indium tin zinc oxide (ITZO). In another example, the first through third pixel electrodes AE1 through AE3 may have a stacked structure of ITO/Ag/ITO, ITO/Ag/IZO, or ITO/Ag/ITZO/IZO.

A sacrificial layer SFL may be disposed on the first through third pixel electrodes AE1 through AE3. The sacrificial layer SFL may be disposed between upper surfaces of the first through third pixel electrodes AE1 through AE3 and a first insulating layer IL1. The sacrificial layer SFL may include an oxide semiconductor. For example, the sacrificial layer SFL may include at least one of indium gallium zinc oxide (IGZO), zinc tin oxide (ZTO), and indium zinc oxide (IZO).

The first insulating layer IL1 may be disposed on the thin-film transistor layer TFTL and the sacrificial layer SFL. The first insulating layer IL1 may include an inorganic insulating material. The first insulating layer IL1 may include, but is not limited to, at least one of a silicon nitride layer, a silicon oxynitride layer, a silicon oxide layer, a titanium oxide layer, an aluminium oxide layer, and an amorphous silicon layer.

A first bank BNK1 may be disposed on the first insulating layer IL1, and a second bank BNK2 may be disposed on the first bank BNK1. A thickness of the first bank BNK1 may be greater than that of the second bank BNK2. The first bank BNK1 may include a metal material having high electrical conductivity, and the second bank BNK2 may include a material having low reflectivity. For example, the first bank BNK1 may include aluminium (Al), and the second bank BNK2 may include titanium (Ti). However, the disclosure is not limited thereto.

A photoresist PR may be disposed on the second bank BNK2 not to overlap the first through third pixel electrodes AE1 through AE3. The photoresist PR may be provided except for areas where first through third emission areas EA1 through EA3 are to be formed.

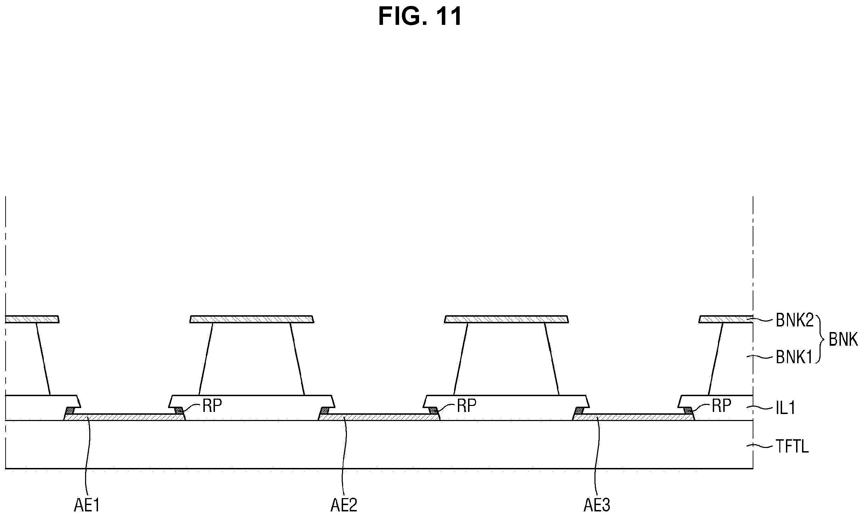

In FIG. 11, the second bank BNK2 and the first bank BNK1 may be sequentially etched to form holes. The holes may overlap the first through third emission areas EA1 through EA3. The first and second banks BNK1 and BNK2 may be etched by performing at least one of a dry etching process and a wet etching process. The first and second banks BNK1 and BNK2 may include different metal materials, and etching rates of the first and second banks BNK1 and BNK2 may be different from each other. The etching rate of the first bank BNK1 may be higher than that of the second bank BNK2, and the first bank BNK1 may be etched more than the second bank BNK2. Therefore, the side shape of the first and second banks BNK1 and BNK2 may be determined by a difference in etching rate between the first and second banks BNK1 and BNK2. The second bank BNK2 may include tips protruding from the first bank BNK1 toward the holes. Side surfaces of the first bank BNK1 may be recessed inward from side surfaces of the second bank BNK2. An undercut structure may be formed under the tips of the second bank BNK2. The thickness of the first bank BNK1 may be greater than that of the second bank BNK2.

The first insulating layer IL1 and the sacrificial layer SFL may be etched by performing at least one of a dry etching process and a wet etching process. As the first insulating layer IL1 and the sacrificial layer SFL are etched, at least a portion of the upper surface of each of the first through third pixel electrodes AE1 through AE3 may be exposed. An etching rate of the sacrificial layer SFL may be higher than an etching rate of the first insulating layer IL1. The sacrificial layer SFL may be etched more than the first insulating layer IL1 in plan view. In the case that the sacrificial layer SFL is etched, a residual pattern RP may remain between the first insulating layer IL1 and the first pixel electrode AE1. An undercut structure may be formed under the first insulating layer IL1. Accordingly, side surfaces of the residual pattern RP may be recessed inward from side surfaces of the first insulating layer IL1.

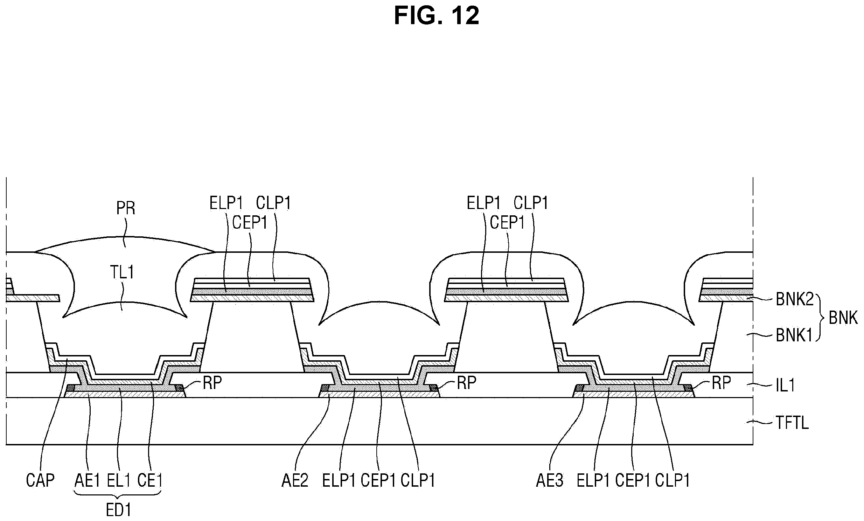

In FIG. 12, a first light emitting layer EL1 may be directly disposed on the first pixel electrode AE1 in the first emission area EA1. A portion of the first light emitting layer EL1 may fill a space surrounded by the first pixel electrode AE1, the residual pattern RP and the first insulating layer IL1, and another portion of the first light emitting layer EL1 may cover a portion of an upper surface of the first insulating layer IL1 and the side surfaces of the first insulating layer IL1.

An organic material for forming the first light emitting layer EL1 and a first organic pattern ELP1 may be deposited on the entire surface of the display device 10. The first light emitting layer EL1 and the first organic pattern ELP1 may be deposited in the same process, but may be cut and separated by the tips of the second bank BNK2. A portion of the first organic pattern ELP1 may be disposed on the second bank BNK2. Another portion of the first organic pattern ELP1 may be disposed on the second pixel electrode AE2 in the second emission area EA2 and may be disposed on the third pixel electrode AE3 in the third emission area EA3.

A first common electrode CE1 may be directly disposed on the first light emitting layer EL1 in the first emission area EA1. The first common electrode CE1 may contact the side surfaces of the first bank BNK1. The first common electrode CE1 may include a transparent conductive material and transmit light generated from the first light emitting layer EL1. Therefore, a first light emitting element ED1 may be disposed in a hole formed by the bank BNK and may emit light through the first emission area EA1.

A metal material for forming the first common electrode CE1 and a first electrode pattern CEP1 may be deposited on the entire surface of the display device 10. The first common electrode CE1 and the first electrode pattern CEP1 may be deposited in the same process, but may be cut and separated by the tips of the second bank BNK2. A portion of the first electrode pattern CEP1 may be disposed on the first organic pattern ELP1 on the second bank BNK2. Another portion of the first electrode pattern CEP1 may be disposed on the first organic pattern ELP1 in each of the second and third emission areas EA2 and EA3. Therefore, the first electrode pattern CEP1 may be disposed on the first organic pattern ELP1 in areas other than the first emission area EA1.

A capping layer CAP may be disposed on the first common electrode CE1 in the first emission area EA1. The capping layer CAP may include an inorganic insulating material and may cover the first light emitting element ED1. The capping layer CAP may prevent the first light emitting element ED1 from being damaged by external air. For example, the capping layer CAP may include, but is not limited to, at least one of a silicon nitride layer, a silicon oxynitride layer, a silicon oxide layer, a titanium oxide layer, an aluminium oxide layer, and an amorphous silicon layer.

An inorganic material for forming the capping layer CAP and a first capping pattern CLP1 may be deposited on the entire surface of the display device 10. The capping layer CAP and the first capping pattern CLP1 may be deposited in the same process, but may be cut and separated by the tips of the second bank BNK2. A portion of the first capping pattern CLP1 may be disposed on the first electrode pattern CEP1 on the second bank BNK2. Another portion of the first capping pattern CLP1 may be disposed on the first electrode pattern CEP1 in each of the second and third emission areas EA2 and EA3. Therefore, the first capping pattern CLP1 may be disposed on the first electrode pattern CEP1 in the areas other than the first emission area EA1.

An inorganic material for forming a first inorganic layer TL1 may be deposited on the entire surface of the display device 10. The first inorganic layer TL1 may cover an upper surface of the capping layer CAP in the first emission area EA1 and may cover an upper surface of the first capping pattern CLP1 in the areas other than the first emission area EA1. The first inorganic layer TL1 may cover the side surfaces of the first bank BNK1, lower and side surfaces of the tips of the second bank BNK2, side surfaces of the first organic pattern ELP1 disposed on the second bank BNK2, side surfaces of the first electrode pattern CEP1, and upper and side surfaces of the first capping pattern CLP1. The first inorganic layer TL1 may include an inorganic material to prevent oxygen or moisture from penetrating into the first light emitting element ED1. The first inorganic layer TL1 may be an inorganic encapsulation layer. For example, the first inorganic layer TL1 may include, but is not limited to, at least one of a silicon nitride layer, a silicon oxynitride layer, a silicon oxide layer, a titanium oxide layer, an aluminium oxide layer, and an amorphous silicon layer.

A photoresist PR may be disposed on the first inorganic layer TL1 to overlap the first emission area EA1. Therefore, the photoresist PR may determine the planar shape and area of the first inorganic layer TL1 protecting the first light emitting element ED1.

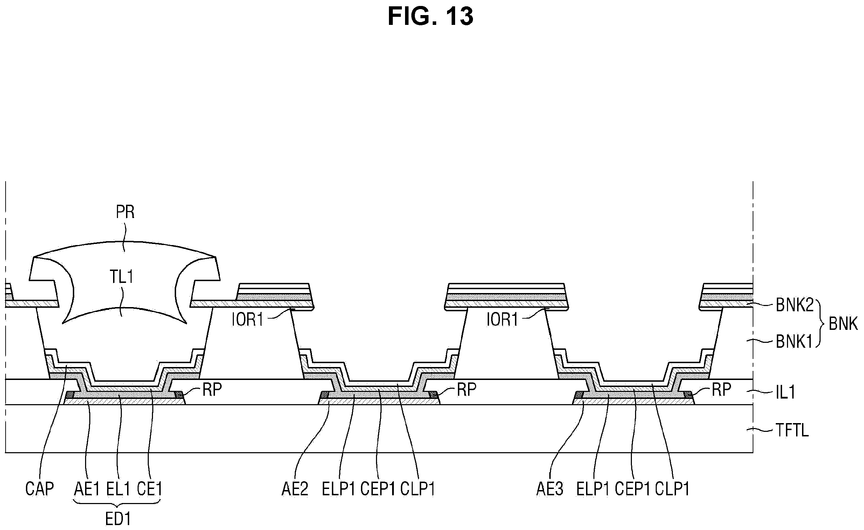

In FIG. 13, the first inorganic layer TL1 not overlapping the photoresist PR may be etched through an etching process. The first inorganic layer TL1 may be etched by performing at least one of a dry etching process and a wet etching process. A first residual inorganic layer IOR1 may be disposed on the lower surfaces of the tips of the second bank BNK2 adjacent to each of the second and third emission areas EA2 and EA3. The first residual inorganic layer IOR1 may be formed in the case that the material that forms the first inorganic layer TL1 is not completely removed from the lower surfaces of the tips of the second bank BNK2 in the process of etching the first inorganic layer TL1. Therefore, the first residual inorganic layer IOR1 may include the same material as the first inorganic layer TL1. A thickness of the first residual inorganic layer IOR1 may be smaller than the thickness of the second bank BNK2.

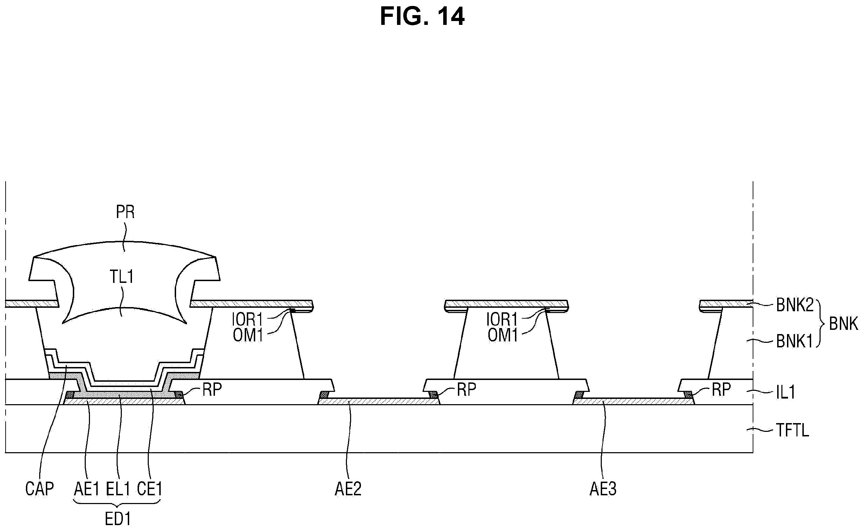

In FIG. 14, the first capping pattern CLP1, the first electrode pattern CEP1, and the first organic pattern ELP1 may be etched through an etching process. For example, the first capping pattern CLP1, the first electrode pattern CEP1, and the first organic pattern ELP1 may be etched by performing at least one of a dry etching process and a wet etching process. Therefore, the second pixel electrode AE2 may be exposed in the second emission area EA2, and the third pixel electrode AE3 may be exposed in the third emission area EA3.

A first oxide layer OM1 may cover a lower surface of the first residual inorganic layer IOR1. The first oxide layer OM1 may be formed by oxidation of the surface of the first residual inorganic layer IOR1 in the process of etching the first capping pattern CLP1, the first electrode pattern CEP1, and the first organic pattern ELP1.

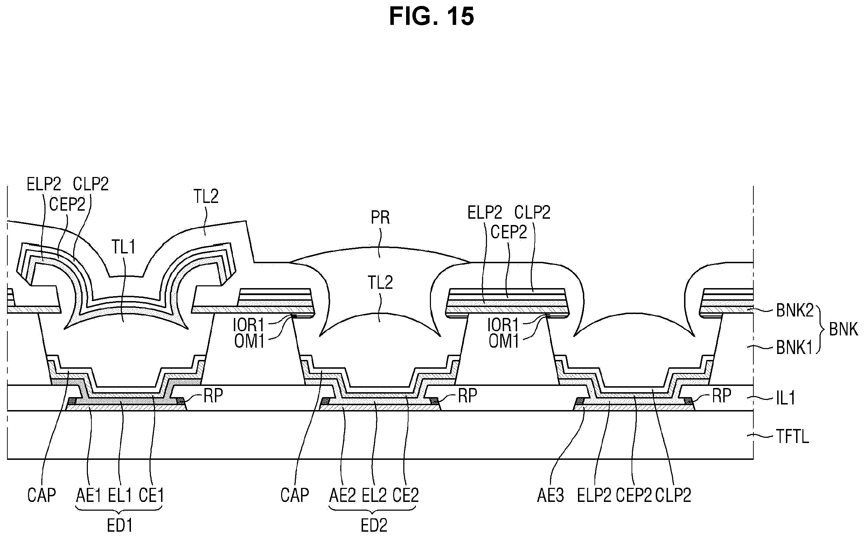

In FIG. 15, a second light emitting layer EL2 may be directly disposed on the second pixel electrode AE2 in the second emission area EA2. A portion of the second light emitting layer EL2 may fill a space surrounded by the second pixel electrode AE2, a residual pattern RP and the first insulating layer IL1, and another portion of the second light emitting layer EL2 may cover a portion of the upper surface of the first insulating layer IL1 and the side surfaces of the first insulating layer IL1.

An organic material for forming the second light emitting layer EL2 and a second organic pattern ELP2 may be deposited on the entire surface of the display device 10. The second light emitting layer EL2 and the second organic pattern ELP2 may be deposited in the same process, but may be cut and separated by the tips of the second bank BNK2. A portion of the second organic pattern ELP2 may be disposed on the second bank BNK2, another portion of the second organic pattern ELP2 may be disposed on the first inorganic layer TL1 in the first emission area EA1, and another portion of the second organic pattern ELP2 may be disposed on the third pixel electrode AE3 in the third emission area EA3.

A second common electrode CE2 may be directly disposed on the second light emitting layer EL2 in the second emission area EA2. The second common electrode CE2 may contact the side surfaces of the first bank BNK1. The second common electrode CE2 may include a transparent conductive material and transmit light generated from the second light emitting layer EL2. Therefore, a second light emitting element ED2 may be disposed in a hole formed by the bank BNK and may emit light through the second emission area EA2.

A metal material for forming the second common electrode CE2 and a second electrode pattern CEP2 may be deposited on the entire surface of the display device 10. The second common electrode CE2 and the second electrode pattern CEP2 may be deposited in the same process, but may be cut and separated by the tips of the second bank BNK2. A portion of the second electrode pattern CEP2 may be disposed on the second organic pattern ELP2 on the second bank BNK2, another portion of the second electrode pattern CEP2 may be disposed on the second organic pattern ELP2 on the first inorganic layer TL1, and another portion of the second electrode pattern CEP2 may be disposed on the second organic pattern ELP2 in the third emission area EA3. Therefore, the second electrode pattern CEP2 may be disposed on the second organic pattern ELP2 in areas other than the second emission area EA2.

A capping layer CAP may be disposed on the second common electrode CE2 in the second emission area EA2. The capping layer CAP may include an inorganic insulating material and may cover the second light emitting element ED2. The capping layer CAP may prevent the second light emitting element ED2 from being damaged by external air.

An inorganic material for forming the capping layer CAP and a second capping pattern CLP2 may be deposited on the entire surface of the display device 10. The capping layer CAP and the second capping pattern CLP2 may be deposited in the same process, but may be cut and separated by the tips of the second bank BNK2. A portion of the second capping pattern CLP2 may be disposed on the second electrode pattern CEP2 on the second bank BNK2, another portion of the second capping pattern CLP2 may be disposed on the second electrode pattern CEP2 on the first inorganic layer TL1, and another portion of the second capping pattern CLP2 may be disposed on the second electrode pattern CEP2 in the third emission area EA3. Therefore, the second capping pattern CLP2 may be disposed on the second electrode pattern CEP2 in the areas other than the second emission area EA2.

An inorganic material for forming a second inorganic layer TL2 may be deposited on the entire surface of the display device 10. The second inorganic layer TL2 may cover an upper surface of the capping layer CAP in the second emission area EA2 and may cover an upper surface of the second capping pattern CLP2 in the areas other than the second emission area EA2. The second inorganic layer TL2 may cover the side surfaces of the first bank BNK1, lower and side surfaces of the first oxide layer OM1, the side surfaces of the tips of the second bank BNK2, side surfaces of the second organic pattern ELP2 disposed on the second bank BNK2, side surfaces of the second electrode pattern CEP2, and upper and side surfaces of the second capping pattern CLP2. The second inorganic layer TL2 may include an inorganic material to prevent oxygen or moisture from penetrating into the second light emitting element ED2. The second inorganic layer TL2 may be an inorganic encapsulation layer. For example, the second inorganic layer TL2 may be made of various materials, e.g., any of the materials that may be used to form the first inorganic layer TL1 as discussed herein.

The first residual inorganic layer IOR1 and the first oxide layer OM1 disposed on the lower surfaces of the tips of the second bank BNK2 adjacent to the second emission area EA2 may increase a thickness of a tip structure that forms the second light emitting element ED2. Therefore, since the first residual inorganic layer IOR1 and the first oxide layer OM1 may not be disposed on the lower surfaces of the tips of the second bank BNK2 adjacent to the first emission area EA1, the thickness of the tip structure that forms the second light emitting element ED2 may be greater than a thickness of a tip structure that forms the first light emitting element ED1. Even if the thickness of the tip structure that forms the second light emitting element ED2 increases, the reliability of the second light emitting element ED2 can be secured.

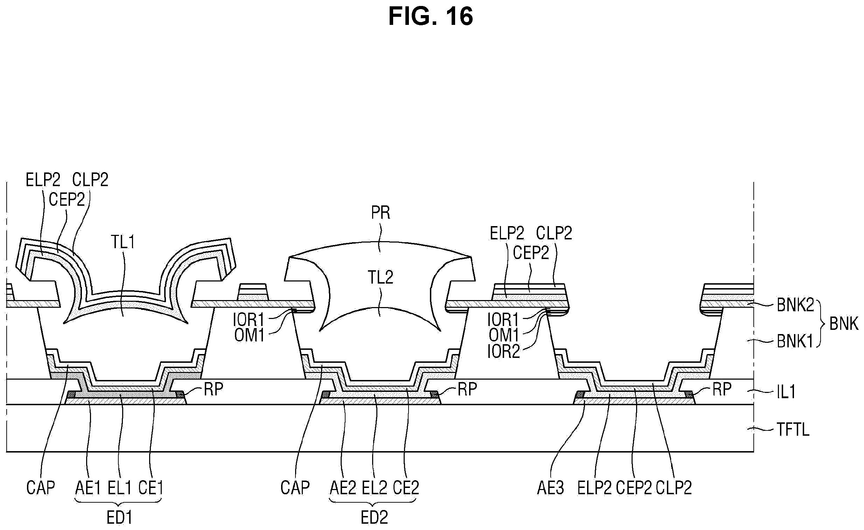

In FIG. 16, the second inorganic layer TL2 not overlapping a photoresist PR may be etched through an etching process. The second inorganic layer TL2 may be etched by performing at least one of a dry etching process and a wet etching process. A second residual inorganic layer IOR2 may be disposed on the lower surface of the first oxide layer OM1 adjacent to the third emission area EA3. The second residual inorganic layer IOR2 may be formed in the case that the material that forms the second inorganic layer TL2 is not completely removed from the lower surface of the first oxide layer OM1 in the process of etching the second inorganic layer TL2. Therefore, the second residual inorganic layer IOR2 may include the same material as the second inorganic layer TL2. A thickness of the second residual inorganic layer IOR2 may be smaller than the thickness of the second bank BNK2.

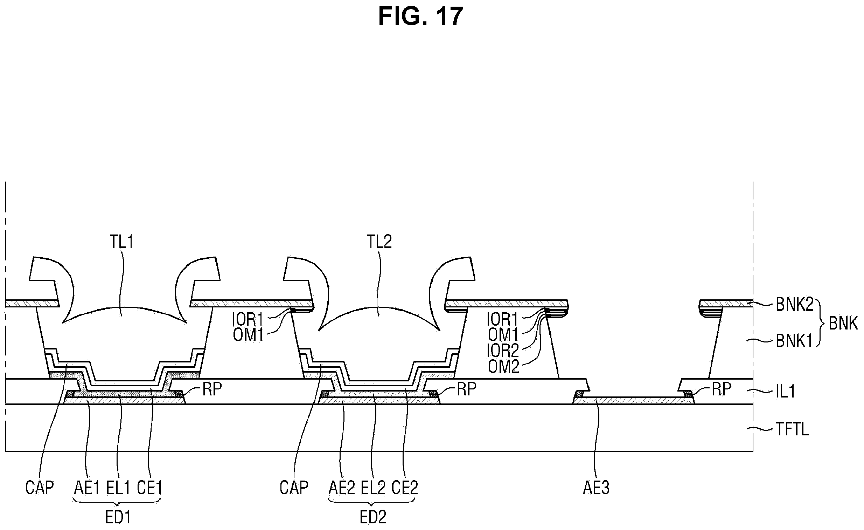

In FIG. 17, the second capping pattern CLP2, the second electrode pattern CEP2, and the second organic pattern ELP2 may be etched through an etching process. For example, the second capping pattern CLP2, the second electrode pattern CEP2, and the second organic pattern ELP2 may be etched by performing at least one of a dry etching process and a wet etching process. Therefore, the third pixel electrode AE3 may be exposed in the third emission area EA3.

A second oxide layer OM2 may cover a lower surface of the second residual inorganic layer IOR2. The second oxide layer OM2 may be formed by oxidation of the surface of the second residual inorganic layer IOR2 in the process of etching the second capping pattern CLP2, the second electrode pattern CEP2, and the second organic pattern ELP2.

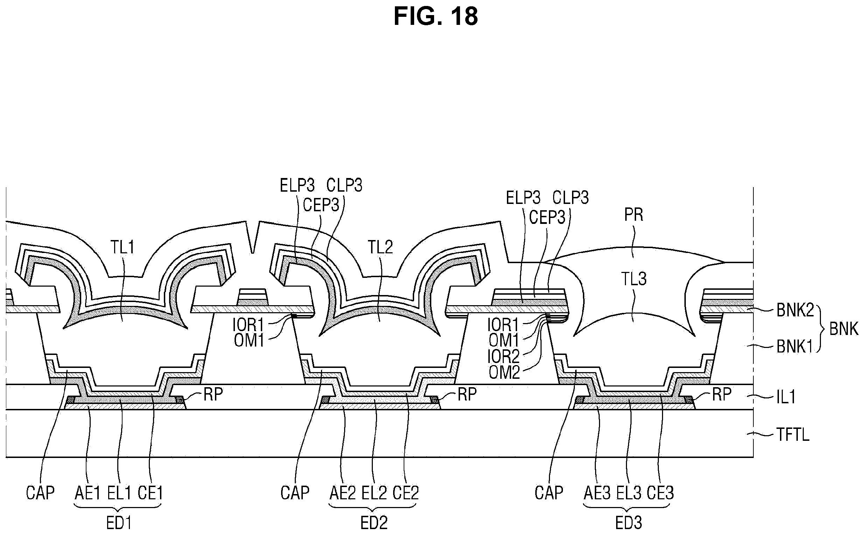

In FIG. 18, a third light emitting layer EL3 may be directly disposed on the third pixel electrode AE3 in the third emission area EA3. A portion of the third light emitting layer EL3 may fill a space surrounded by the third pixel electrode AE3, a residual pattern RP and the first insulating layer IL1, and another portion of the third light emitting layer EL3 may cover a portion of the upper surface of the first insulating layer IL1 and the side surfaces of the first insulating layer IL1.

An organic material for forming the third light emitting layer EL3 and a third organic pattern ELP3 may be deposited on the entire surface of the display device 10. The third light emitting layer EL3 and the third organic pattern ELP3 may be deposited in the same process, but may be cut and separated by the tips of the second bank BNK2. A portion of the third organic pattern ELP3 may be disposed on the second bank BNK2, another portion of the third organic pattern ELP3 may be disposed on the first inorganic layer TL1 in the first emission area EA1, and another portion of the third organic pattern ELP3 may be disposed on the second inorganic layer TL2 in the second emission area EA2.

A third common electrode CE3 may be directly disposed on the third light emitting layer EL3 in the third emission area EA3. The third common electrode CE3 may contact the side surfaces of the first bank BNK1. The third common electrode CE3 may include a transparent conductive material and transmit light generated from the third light emitting layer EL3. Therefore, a third light emitting element ED3 may be disposed in a hole formed by the bank BNK and may emit light through the third emission area EA3.

A metal material for forming the third common electrode CE3 and a third electrode pattern CEP3 may be deposited on the entire surface of the display device 10. The third common electrode CE3 and the third electrode pattern CEP3 may be deposited in the same process, but may be cut and separated by the tips of the second bank BNK2. A portion of the third electrode pattern CEP3 may be disposed on the third organic pattern ELP3 on the second bank BNK2, another portion of the third electrode pattern CEP3 may be disposed on the third organic pattern ELP3 on the first inorganic layer TL1, and another portion of the third electrode pattern CEP3 may be disposed on the third organic pattern ELP3 on the second inorganic layer TL2. Therefore, the third electrode pattern CEP3 may be disposed on the third organic pattern ELP3 in areas other than the third emission area EA3.

A capping layer CAP may be disposed on the third common electrode CE3 in the third emission area EA3. The capping layer CAP may include an inorganic insulating material and may cover the third light emitting element ED3. The capping layer CAP may prevent the third light emitting element ED3 from being damaged by external air.

An inorganic material for forming the capping layer CAP and a third capping pattern CLP3 may be deposited on the entire surface of the display device 10. The capping layer CAP and the third capping pattern CLP3 may be deposited in the same process, but may be cut and separated by the tips of the second bank BNK2. A portion of the third capping pattern CLP3 may be disposed on the third electrode pattern CEP3 on the second bank BNK2, another portion of the third capping pattern CLP3 may be disposed on the third electrode pattern CEP3 on the first inorganic layer TL1, and another portion of the third capping pattern CLP3 may be disposed on the third electrode pattern CEP3 on the second inorganic layer TL2. Therefore, the third capping pattern CLP3 may be disposed on the third electrode pattern CEP3 in the areas other than the third emission area EA3.

An inorganic material for forming a third inorganic layer TL3 may be deposited on the entire surface of the display device 10. The third inorganic layer TL3 may cover an upper surface of the capping layer CAP in the third emission area EA3 and may cover an upper surface of the third capping pattern CLP3 in the areas other than the third emission area EA3. The third inorganic layer TL3 may cover the side surfaces of the first bank BNK1, lower and side surfaces of the second oxide layer OM2, the side surfaces of the first oxide layer OM1, the side surfaces of the tips of the second bank BNK2, side surfaces of the third organic pattern ELP3 disposed on the second bank BNK2, side surfaces of the third electrode pattern CEP3, and upper and side surfaces of the third capping pattern CLP3. The third inorganic layer TL3 may include an inorganic material to prevent oxygen or moisture from penetrating into the third light emitting element ED3. The third inorganic layer TL3 may be an inorganic encapsulation layer. For example, the third inorganic layer TL3 may be made of various materials, e.g., any of the materials that may be used to form the first inorganic layer TL1 as discussed herein.

The first residual inorganic layer IOR1, the first oxide layer OM1, the second residual inorganic layer IOR2, and the second oxide layer OM2 disposed on the lower surfaces of the tips of the second bank BNK2 adjacent to the third emission area EA3 may increase a thickness of a tip structure that forms the third light emitting element ED3. Therefore, since the second residual inorganic layer IOR2 and the second oxide layer OM2 may not be disposed on the lower surfaces of the tips of the second bank BNK2 adjacent to the second emission area EA2, the thickness of the tip structure that forms the third light emitting element ED3 may be greater than the thickness of the tip structure that forms the second light emitting element ED2. Even if the thickness of the tip structure that forms the third light emitting element ED3 increases, the reliability of the third light emitting element ED2 can be secured.

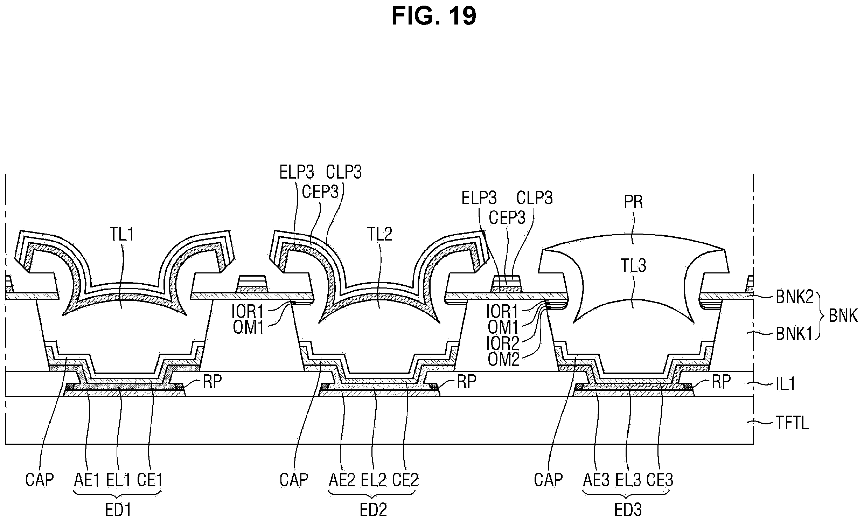

In FIG. 19, the third inorganic layer TL3 not overlapping a photoresist PR may be etched through an etching process. The third inorganic layer TL3 may be etched by performing at least one of a dry etching process and a wet etching process.

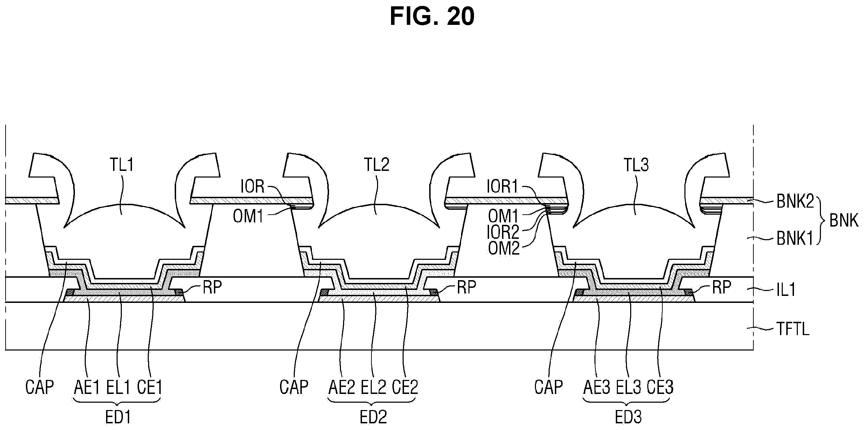

In FIG. 20, the third capping pattern CLP3, the third electrode pattern CEP3, and the third organic pattern ELP3 may be etched through an etching process. For example, the third capping pattern CLP3, the third electrode pattern CEP3, and the third organic pattern ELP3 may be etched by performing at least one of a dry etching process and a wet etching process.

In the display device and a method of manufacturing the same according to embodiments, the display device may be manufactured through a process in which a thickness of a tip structure that forms a second light emitting element is greater than a thickness of a tip structure that forms a first light emitting element, and a thickness of a tip structure that forms a third light emitting element is greater than the thickness of the tip structure that forms the second light emitting element. Therefore, it is possible to secure reliability of the light emitting elements while minimizing a mask process.

The above description is an example of technical features of the disclosure, and those skilled in the art to which the disclosure pertains will be able to make various modifications and variations. Thus, the embodiments of the disclosure described above may be implemented separately or in combination with each other.

The embodiments disclosed in the disclosure are intended not to limit the technical idea of the disclosure but to describe the technical idea of the disclosure, and the scope of the technical idea of the disclosure is not limited by these embodiments. The protection scope of the disclosure should be interpreted by the following claims, and it should be interpreted that all technical ideas within the equivalent scope are included in the scope of the disclosure.

## Claims

1. A display device comprising:
a first pixel electrode disposed on a substrate in a first emission area;
a second pixel electrode disposed on the substrate in a second emission area, the first and second pixel electrodes being disposed on a same layer;
an insulating layer covering edges of an upper surface of each of the first and second pixel electrodes;
a first light emitting layer disposed on the first pixel electrode and the insulating layer;
a first common electrode disposed on the first light emitting layer;
a first bank disposed on the insulating layer;
a second bank disposed on the first bank and including tips that protrude from side surfaces of the first bank toward each of the first and second emission areas;
a first residual inorganic layer disposed on lower surfaces of the tips of the second bank adjacent to the second emission area; and
a first oxide layer covering a lower surface of the first residual inorganic layer.

2. The display device of claim 1, further comprising:
a capping layer disposed on the first common electrode in the first emission area; and
a first inorganic layer covering an upper surface of the capping layer of the first emission area, the side surfaces of the first bank, and lower surfaces and side surfaces of the tips of the second bank, optionally wherein the first residual inorganic layer and the first inorganic layer include a same material.

3. The display device of claim 1 or claim 2, wherein the first oxide layer is formed by oxidation of a surface of the first residual inorganic layer.

4. The display device of any one of claims 1 to 3, further comprising:
a second light emitting layer disposed on the second pixel electrode and the insulating layer;
a second common electrode disposed on the second light emitting layer; and
a third pixel electrode disposed in a third emission area, the first, second, and third pixel electrodes being disposed on a same layer,
wherein the second bank includes tips protruding toward the third emission area.

5. The display device of claim 4, wherein
the first residual inorganic layer is additionally disposed on the lower surfaces of the tips of the second bank adjacent to the third emission area, and
the first oxide layer additionally covers the lower surface of the first residual inorganic layer adjacent to the third emission area.

6. The display device of claim 5, further comprising:
a second residual inorganic layer disposed on a lower surface of the first oxide layer adjacent to the third emission area; and
a second oxide layer covering a lower surface of the second residual inorganic layer.

7. The display device of claim 6, further comprising:
a capping layer disposed on the second common electrode in the second emission area; and
a second inorganic layer covering an upper surface of the capping layer of the second emission area, the side surfaces of the first bank, lower surfaces and side surfaces of the first oxide layer, and the side surfaces of the tips of the second bank, optionally wherein the second residual inorganic layer and the second inorganic layer include a same material.

8. The display device of claim 6 or claim 7, wherein the second oxide layer is formed by oxidation of a surface of the second residual inorganic layer.

9. The display device of any one of claims 1 to 8, further comprising:
a third bank disposed on the second bank; and
a fourth bank disposed on the third bank and including tips that protrude from side surfaces of the third bank toward each of the first and second emission areas.

10. A display device comprising:
a first pixel electrode disposed on a substrate in a first emission area;
a second pixel electrode disposed on a substrate in a second emission area, the first and second pixel electrodes being disposed on a same layer;
a residual pattern disposed on edges of an upper surface of each of the first and second pixel electrodes;
an insulating layer covering edges of the first and second pixel electrodes and an upper surface of the residual pattern;
a first light emitting layer disposed on the first pixel electrode and the insulating layer;
a first common electrode disposed on the first light emitting layer;
a first bank disposed on the insulating layer;
a second bank disposed on the first bank; and
a third bank disposed on the second bank and including tips that protrude from side surfaces of the second bank toward each of the first and second emission areas, wherein
the second bank and the residual pattern include a same material, and
the third bank and the insulating layer include a same material.

11. The display device of claim 10, further comprising:
(i) a first residual inorganic layer disposed on lower surfaces of tips of the second bank adjacent to the second emission area; and
a first oxide layer covering a lower surface of the first residual inorganic layer; and/or
(ii) a second light emitting layer disposed on the second pixel electrode and the insulating layer;
a second common electrode disposed on the second light emitting layer; and
a third pixel electrode disposed in a third emission area, the first, second, and third pixel electrodes being disposed on a same layer,
wherein the third bank includes tips protruding toward the third emission area, optionally further comprising:
a first residual inorganic layer disposed on lower surfaces of the tips of the third bank adjacent to the third emission area;
a first oxide layer covering a lower surface of the first residual inorganic layer;
a second residual inorganic layer disposed on a lower surface of the first oxide layer; and
a second oxide layer covering a lower surface of the second residual inorganic layer.

12. A method of manufacturing a display device, the method comprising:
forming a first pixel electrode in a first emission area, forming a second pixel electrode in a second emission area, and forming a third pixel electrode in a third emission area on a substrate;
sequentially stacking a sacrificial layer, an insulating layer, a first bank, and a second bank on the first through third pixel electrodes;
forming tips of the second bank which protrude from side surfaces of the first bank by etching the second bank and the first bank;
exposing the first through third pixel electrodes by etching the insulating layer and the sacrificial layer;
sequentially stacking a first light emitting layer, a first common electrode, and a capping layer on the first pixel electrode and sequentially stacking a first organic pattern, a first electrode pattern, and a first capping pattern in areas other than the first emission area;
forming a first inorganic layer on the capping layer and the first capping pattern; and
forming a first residual inorganic layer on lower surfaces of the tips of the second bank adjacent to each of the second and third emission areas by etching the first inorganic layer in the areas other than the first emission area.

13. The method of claim 12, further comprising:
forming a first oxide layer covering a lower surface of the first residual inorganic layer by etching the first organic pattern, the first electrode pattern, and the first capping pattern.

14. The method of claim 13, further comprising:
sequentially stacking a second light emitting layer, a second common electrode, and a capping layer on the second pixel electrode and sequentially stacking a second organic pattern, a second electrode pattern, and a second capping pattern in areas other than the second emission area;
forming a second inorganic layer on the capping layer and the second capping pattern; and
forming a second residual inorganic layer on a lower surface of the first oxide layer adjacent to the third emission area by etching the second inorganic layer in the areas other than the second emission area.

15. The method of claim 14, further comprising:
forming a second oxide layer covering a lower surface of the second residual inorganic layer by etching the second organic pattern, the second electrode pattern, and the second capping pattern, optionally further comprising:
sequentially stacking a third light emitting layer, a third common electrode, and a capping layer on the third pixel electrode and sequentially stacking a third organic pattern, a third electrode pattern, and a third capping pattern in areas other than the third emission area;
forming a third inorganic layer on the capping layer and the third capping pattern; and
etching the third inorganic layer, the third organic pattern, the third electrode pattern, and the third capping pattern in the areas other than the third emission area.
